# EUROPÄISCHE PATENTANMELDUNG

(11) **EP 3 875 637 A1**
(43) Veröffentlichungstag der Anmeldung: **08.09.2021**
(21) Anmeldenummer: 20172906.8
(22) Anmeldetag: 05.05.2020
(51) Int. Cl.: C25D 21/18, C25D 21/22, C25C 3/00, C25D 21/14, C25D 3/38

(54) **VERFAHREN ZUM RÜCKGEWINNEN EINES ELEMENTAREN METALLS AUS DER LEITERPLATTEN- UND/ODER SUBSTRAT-HERSTELLUNG**

(30) Priorität: 04.03.2020 EP 20160862
(71) Anmelder: AT & S Austria Technologie & Systemtechnik Aktiengesellschaft, 8700 Leoben-Hinterberg (AT)
(72) Erfinder: Klocek, Jolanta, 8712 Niklasdorf (AT); Payerl, Claudia, 8020 Graz (AT); Frey, Gerhard, 8793 Trofaiach (AT); Schrei, Martin, 8382 Mogersdorf (AT); Redl, Alois, 8712 Niklasdorf (AT); Ebinger, Christoph, 70599 Stuttgart (DE); Herzog, René, 8045 Graz (AT); Zanker, Andreas, 8753 Fohnsdorf (AT); Mandl, Thomas, 8720 Knittelfeld (AT); Gross, Friedrich, 8700 Leoben (AT); Kern, Konstantin, 8700 Leoben (AT); Moitzi, Heinz, 8740 Zeltweg (AT)
(74) Vertreter: Dilg, Haeusler, Schindelmann Patentanwaltsgesellschaft mbH

(57) **Zusammenfassung**

Es wird ein Verfahren (400) zum Aufbereiten eines Metallsalz-haltigen Mediums (40) aus der Leiterplatten- und/oder Substrat-Herstellung beschrieben. Das Verfahren aufweisend: i) Bereitstellen (405) des Metallsalz-haltigen Mediums (40), welches ein Metallsalz und ein Fremdmetall aufweist, wobei das Fremdmetall chemisch unedler ist als das Metall, ii) Rückgewinnen des elementaren Metalls (50) aus dem Metallsalz-haltigen Medium (40) in einer Reaktionszelle (450), insbesondere mittels Elektrolyse (451), und im Wesentlichen zeitgleich iii) Oxidieren (452) des Fremdmetalls.

## Beschreibung

Die Erfindung betrifft ein Verfahren zum Aufbereiten eines Metallsalz-haltigen Mediums aus der Leiterplatten- und/oder Substrat-Herstellung. Weiterhin betrifft die Erfindung eine Vorrichtung, insbesondere eine Industrieanlage, zum Ausführen des Verfahrens. Ferner betrifft die Erfindung ein Verwenden von Eisenchlorid, welches durch das Verfahren bereitgestellt wird. Außerdem betrifft die Erfindung eine Prozesskontrollvorrichtung zum Regulieren des Verfahrens und/oder der Vorrichtung. Weiterhin betrifft die Erfindung ein Computerprogramm-Produkt zum Steuern des Verfahrens und/oder der Vorrichtung und/oder der Prozesskontrollvorrichtung.

Die Erfindung kann sich somit auf das technische Gebiet der Leiterplattenund/oder Substrat-Herstellung beziehen. Insbesondere kann sich die Erfindung auf das technische Gebiet des Aufbereitens (insbesondere Rückgewinnen) von Metallsalz-haltigem Medium aus der Leiterplatten- und/oder Substrat-Herstellung beziehen. Weiter kann sich die Erfindung auf das technische Gebiet des Recycelns innerhalb der Leiterplatten- und/oder Substrat-Herstellung beziehen.

Für die Erzeugung von Leiterplatten und/oder Substraten werden prinzipiell große Mengen an Metallen, insbesondere Schwermetallen (z.B. Kupfer, Nickel, Gold, Silber, Palladium, Zinn, Eisen) benötigt. Innerhalb des Herstellungsprozesses fallen daher aus den unterschiedlichen Prozessen Metall-haltige Rückstände bzw. Metall-haltige Medien (insbesondere Lösungen) an.

Die aufzubereitenden Metall (-salz)-haltigen Medien (bzw. zu reinigenden Abfallund Rückstandskonzentrate) stammen im Wesentlichen aus zwei unterschiedlichen Verarbeitungsprozessen bei der Leiterplatten- und/oder Substrat-Herstellung: i) dem Ätzprozess (z.B. Ätzen von Kupferfolien) und ii) dem Galvanikprozess (z.B. Galvanisieren mit Kupferschichten). Zudem fallen aufzubereitende Metall (-salz)-haltige Medien während Spülprozessen sowohl aus dem Ätzprozess als auch aus dem Galvanikprozess an. Diese Spülwässer enthalten nur geringe Konzentrationen an Metall, insbesondere Kupfer. Die aufzubereitenden Metall (-salz)-haltigen Medien aus den Ätzprozessen und den Galvanikprozessen weisen hingegen vergleichsweise hohe Konzentrationen an Metall auf.

Ein aufzubereitendes Metall (-salz)-haltiges Medium aus dem Galvanikprozess enthält gewöhnlich ebenfalls ein Metallsalz, in welchem das Metall mit dem Salz einer Säure der Elektrolyse chemisch verbunden vorliegt (beispielsweise Kupfersulfat, wobei das Sulfat aus Schwefelsäure stammt). Zusätzlich weist ein aufzubereitendes Metall (-salz)-haltiges Medium aus dem Galvanikprozess generell Fremdmetalle, beispielsweise Eisen, in hohen Konzentrationen auf. Diese Fremdmetalle können z.B. umfassen: Eisen (Fe³⁺, Fe²⁺), Blei (Pb²⁺), Zinn (Sn²⁺), Molybdän (Mo³⁺), Nickel (Ni²⁺), Kobalt (Co²⁺), Indium (In³⁺), Cadmium (Cd²⁺), Zink (Zn²⁺), Chrom (Cr³⁺), Natrium (Na⁺), Palladium (Pd²⁺).

Es sind zwar prinzipiell Methoden bekannt, Metall aus den beschriebenen Metall (-salz)-haltigen Medien rückzugewinnen. Allerdings ist ein rückgewonnenes Metall für die Leiterplatten- und/oder Substrat-Herstellung nur in hochreiner Form (z.B. 99% bis 99,99%, insbesondere etwa 99,9% rein) von Interesse. Eine solche Rückgewinnung kann z.B. mittels einer Elektrolyse erfolgen. Die oben beschriebenen Metall (-salz)-haltigen Medien sind hierfür allerdings denkbar ungeeignet, denn die Abscheidung von reinem Metall (z.B. Kupfer) ist durch die Zusammensetzung der Metall (-salz)-haltigen Medien behindert und/oder erschwert. So stören bzw. verunmöglichen Fremdmetalle wie Eisen erheblich eine qualitativ hochwertige Elektrolyse. Aus diesem Grund werden konventionell Abfallkonzentrate aus der Leiterplatten- und/oder Substrat-Herstellung auf kostenintensive und wenig umweltfreundliche bzw. nachhaltige Weise entsorgt.

Es ist eine Aufgabe der vorliegenden Erfindung ein kostengünstiges, umweltfreundliches, und nachhaltiges Rückgewinnen eines elementaren Metalls aus der Leiterplatten- und/oder Substrat-Herstellung innerhalb eines Wertstoffkreislaufs (Prozess-internes, bevorzugt kontinuierliches, Recycling) auf effiziente und robuste Weise zu ermöglichen.

Diese Aufgabe wird durch die Gegenstände gemäß den unabhängigen Patentansprüchen gelöst. Bevorzugte Ausgestaltungen ergeben sich aus den abhängigen Patentansprüchen.

Gemäß einem Aspekt der Erfindung wird ein Verfahren zum Aufbereiten eines Metallsalz-haltigen Mediums (z.B. einem Abwasser aus ein oder mehr Herstellungsprozessen) aus der Leiterplatten- und/oder Substrat-Herstellung beschrieben. Das Verfahren aufweisend: i) Bereitstellen des Metallsalz-haltigen Mediums, welches ein Metallsalz (z.B. Kupfersulfat) und ein Fremdmetall(-salz) (z.B. Eisen bzw. Eisensulfat) aufweist, wobei das Fremdmetall chemisch unedler ist als das (abzuscheidende) Metall, ii) Rückgewinnen (bzw. Separieren zum Weiterverwenden) des elementaren Metalls (z.B. mittels Reduzierens) aus dem Metallsalz-haltigen Medium in einem Reaktor, insbesondere einer Reaktionszelle (weiter insbesondere mittels Elektrolyse), und (im Wesentlichen) zeitgleich iii) Oxidieren des Fremdmetalls.

Gemäß einem Aspekt der Erfindung wird eine Vorrichtung zum Aufbereiten eines Metallsalz-haltigen Mediums aus der Leiterplatten- und/oder Substrat-Herstellung beschrieben, wobei das Metallsalz-haltige Medium ein Metallsalz und ein Fremdmetall aufweist, und wobei das Fremdmetall chemisch unedler ist als das Metall. Die Vorrichtung aufweisend eine Reaktionszelle (insbesondere eine Elektrolysezelle), welche eingerichtet ist zum i) Rückgewinnen des elementaren Metalls aus dem Metallsalz-haltigen Medium und (im Wesentlichen) zeitgleich, ii) Oxidieren des Fremdmetalls.

Gemäß einem weiteren Aspekt der vorliegenden Erfindung wird ein Verwenden beschrieben von Eisenchlorid, welches mittels Säure-Regeneration eines Ionentauschers aus Elektrolyse-oxidiertem Eisen, welches aus einer (Abfalllösung der Galvanisierung bei der) Herstellung von Leiterplatten und/oder Substraten stammt, gewonnen wurde, für das Fällen von Fotolack für die Herstellung der Leiterplatten und/oder der Substrate.

Gemäß einem weiteren Aspekt der vorliegenden Erfindung wird ein Verwenden beschrieben eines Fremdmetall (insbesondere Eisen)- und Metallsalz-haltigen Mediums aus einem Rückgewinnungsprozess der Leiterplatten- und/oder Substrat-Herstellung als Ausgangsmaterial zur (kontinuierlichen) Produktion von Eisenchlorid für das Fällen von Fotolack aus der Herstellung von Leiterplatten und/oder Substraten bzw. der Herstellung der Leiterplatten und/oder der Substrate.

Gemäß einem weiteren Aspekt der vorliegenden Erfindung wird eine Prozesskontrollvorrichtung zum Regulieren des oben beschriebenen Verfahrens und/oder der oben beschriebenen Vorrichtung diskutiert. Die Prozesskontrollvorrichtung weist auf: i) eine Datenbank zum Erfassen von zumindest einem Prozessparameter (bzw. einem Ist-Wert), insbesondere einer Mehrzahl von Prozessparametern, aus dem laufenden Prozess, ii) eine Datenmodell-Einheit, welche eingerichtet ist zum Speichern von zumindest einem vorbestimmten Prozessparameter (bzw. einem Soll-Wert), insbesondere einer Mehrzahl von vorbestimmten Prozessparametern, und iii) eine Berechnungsvorrichtung, welche eingerichtet ist zum a) Vergleichen des erfassten Prozessparameters mit dem vorbestimmten Prozessparameter (bzw. der Mehrzahlen miteinander), b) Bestimmen einer Steueroperation, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation (z.B. Flussrate anpassen, etc...).

Gemäß einem weiteren Aspekt der vorliegenden Erfindung wird ein Computerprogramm-Produkt beschrieben zum Steuern eines Verfahrens zum Aufbereiten eines Metallsalz-haltigen Mediums aus der Leiterplatten und/oder Substrat Herstellung, welches Computerprogramm-Produkt, wenn es von einem oder mehreren Prozessoren (bzw. einem oder mehreren Computern) ausgeführt wird, das Verfahren (wie oben beschrieben) und/oder die Vorrichtung (wie oben beschrieben) und/oder die Prozesskontrollvorrichtung (wie oben beschrieben) steuert.

Im Rahmen dieses Dokuments kann unter dem Begriff "Metallsalz-haltiges Medium" insbesondere jegliches (flüssige) Medium verstanden werden, welches ein Metallsalz aufweist. Ein Metallsalz ist eine chemische Verbindung zwischen einem Metall und einer Säure. Beispiele für ein solches Metall können umfassen: Kupfer, Nickel, Gold, Silber, Cobalt, Cadmium, Magnesium, Natrium, Palladium, Zinn. Beispiele für Säuren können umfassen: Schwefelsäure, Salzsäure, Salpetersäure, Phosphorsäure; wobei das Metallsalz entsprechend z.B. als Sulfat, Chlorid, Nitrat, oder Phosphat vorliegt. Entsprechend kann ein Metallsalz z.B. Kupfersulfat oder Kupferchlorid sein. Dieses kann in dem Metallsalz-haltigen Medium als Metall-Ion und Salz-Ion vorliegen. Ein Metallsalz-haltiges Medium kann neben Metallsalz eine Lösung aufweisen, welche z.B. wässrig oder sauer sein kann, in welcher das Metallsalz gelöst ist. Beispielsweise kann das Medium neben Wasser auch Salzsäure und/oder Schwefelsäure aufweisen. In einem Beispiel stammt das Metallsalz-haltige Medium aus der Herstellung von Leiterplatten und/oder Substraten und kann entsprechende Rückstände aufweisen. Ferner kann das Metallsalz-haltige Medium aufbereitet sein, so dass im Wesentlichen nur das Metallsalz vorliegt. In einem Beispiel ist das Metallsalz-haltige Medium (im Wesentlichen) frei von (unerwünschtem) Fremdmetall (wie z.B. Eisen). In einem weiteren Beispiel weist das Metallsalz-haltige Medium (Reste von) Fremdmetall auf.

Im Rahmen dieses Dokuments kann unter dem Begriff "Fremdmetall" insbesondere ein Metall verstanden werden, welches in einem Metallsalz-haltigen Medium (gelöst) vorliegt, aber dort (für bestimmte Anwendungen) nicht erwünscht ist. Beispiele für solche Fremdmetalle (bzw. deren Ionen) können je nach Anwendungsfall umfassen: Eisen (Fe³⁺, Fe²⁺), Blei (Pb²⁺), Zinn (Sn²⁺), Molybdän (Mo³⁺), Nickel (Ni²⁺), Kobalt (Co²⁺), Indium (In³⁺), Cadmium (Cd²⁺), Zink (Zn²⁺), Chrom (Cr³⁺), Natrium (Na⁺), Palladium (Pd²⁺). In einem Ausführungsbeispiel soll ein Metallsalz-haltiges Medium derart aufbereitet werden, dass das Metall des Metallsalzes in elementarer Form vorliegt und recycelt werden kann. Hierbei können die Fremdmetalle eine Störung bis Verunmöglichung des Aufbereitens (z.B. mittels Elektrolyse) bewirken, wodurch sich ein vorheriges Entfernen der Fremdmetalle empfehlen kann. In einem exemplarischen Ausführungsbeispiel stammt das Metallsalz-haltige Medium aus einem Galvanisierungsprozess und elementares Kupfer soll aus dem Metallsalz Kupfersulfat gewonnen werden. Bedingt durch den Galvanisierungsprozess kann das Metallsalz-haltige Medium Fremdmetalle, insbesondere Eisen, aufweisen. Fremdmetalle können als Fremdmetallsalz (z.B. Eisensulfat) vorliegen. Dieses kann die Elektrolyse von Kupfersulfat empfindlich stören (hemmt die Kupferabscheidung an der Kathode). In geringeren (Rest-) Konzentration kann das Fremdmetall während eines Rückgewinnens oxidiert werden, während das Metall reduziert (bzw. abgeschieden) wird.

Im Rahmen dieses Dokuments kann unter dem Begriff "Leiterplatten- und/oder Substrat-Herstellung" insbesondere ein Prozess verstanden werden zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Eine Leiterplatten- und/oder Substrat-Herstellung umfasst gewöhnlich einen Ätzprozess, in welchem Metall mittels Ätzens derart entfernt wird, dass erwünschte Metallstrukturen erhalten werden, und einen Galvanisierungsprozess, in welchem Metall mittels Galvanisierens (plating) aufgetragen wird. Ausgangsmaterial für eine Leiterplatten- und/oder Substrat-Herstellung umfasst im Wesentlichen das Metall sowie elektrisch isolierendes Material, meist ein organisches Material wie ein Harz. Das Produkt des Prozesses kann die fertige Leiterplatte bzw. das Substrat sein, oder auch ein Zwischenprodukt.

Im Rahmen dieses Dokuments können die Begriffe "edel" und "unedel" insbesondere wie folgt verstanden werden: wenn das Standardpotential (Redoxpotential, bzw. nach DIN 38404-6 "Redox-Spannung") eines ersten Metalls höher ist als das Standardpotential eines zweiten Metalls, so ist das erste Metall edler in Bezug zu dem zweiten Metall und das zweite Metall ist unedler in Bezug zu dem ersten Metall. Wenn eine effiziente Elektrolyse mit dem Metall und dem Fremdmetall durchgeführt wird, so soll das Redoxpotential des Fremdmetalls hierfür also niedriger sein als das Redoxpotential des abzuscheidenden Metalls.

Metalle mit hohem Redoxpotential (abzuscheidende Metalle) können beispielsweise umfassen: Kupfer Cu²⁺, E⁰ = +0,35V; Kupfer Cu⁺, E⁰ = +0,52V, Palladium Pd²⁺, E⁰ = +0,85V; Gold Au³⁺, E⁰ = +1,4V; Gold Au³⁺, E⁰ = +1,5V; Gold Au⁺, E⁰ = +1,69V; Iridium Ir³⁺,E⁰ = +1,156V; Silber Ag⁺, E⁰ = +0,8V.

Metalle mit niedrigem Redoxpotential (Fremdmetalle) können beispielsweise umfassen: Eisen Fe³⁺, E⁰ = -0,04V; Eisen Fe²⁺, E⁰ = -0,41V; Blei Pb²⁺ , E⁰ = - 0,13V; Zinn Sn²⁺ , E⁰ = -0,14V; Molybdän Mo³⁺, E⁰ = -0,20V; Nickel Ni²⁺, E⁰ = -0,23V; Kobalt Co²⁺, E⁰ = -0,28V; Indium In³⁺, E⁰ = -0,34V; Cadmium Cd²⁺, E⁰ = -0,40V; Zink Zn²⁺, E⁰ = -0,76V; Chrom Cr³⁺, E⁰ = -0,76V; Natrium Na⁺, E⁰ = -2,71V. Insbesondere bei Eisen (Fe³⁺ -> Fe²⁺, E⁰ = + 0,77) kann eine (unerwünschte) Reaktion stattfinden, bei welcher durch das Fe²⁺ abgeschiedenes Kupfer wieder von der Elektrode weggeätzt wird.

Im Rahmen dieses Dokuments kann mit dem Begriff "Reaktionszelle" insbesondere jeglicher Reaktor bezeichnet werden, welcher es ermöglicht aus einem Metallsalz-haltigen Medium das Metall des Metallsalzes in elementarer und hochreiner Form rückzugewinnen. Der Begriff "Rückgewinnen" kann hierbei insbesondere bezeichnen, dass das elementare Metall aus dem Metallsalz-haltigen Medium (zum Zwecke eines erneuten Verwendens) abgetrennt bzw. separiert wird. Ein Beispiel für eine Reaktionszelle kann eine Elektrolyse-Zelle sein. Der Begriff "Elektrolyse" kann insbesondere bedeuten, dass elektrischer Strom eingesetzt wird, um eine chemische Redoxreaktion zu ermöglichen. Eine Elektrolyse-Zelle kann daher aufweisen: eine Gleichspannungsquelle zum Bereitstellen des elektrischen Stroms, welche gekoppelt ist mit einer Kathode (Minus-Pol) und einer Anode (Plus-Pol). Die Spannungsquelle kann hierbei einen Elektronenmangel in der Anode und einen Elektronenüberschuss in der Kathode verursachen. In einem Ausführungsbeispiel wird der Elektrolyse-Zelle Metallsalz-haltiges Medium zugegeben, welches Kupfer als Metall und Eisen als Fremdmetall aufweist. Kupfer weist das höhere Redoxpotential auf (ist edler) und wird daher an der Kathode reduziert bzw. abgeschieden. Eisen hingegen wird an der Anode oxidiert. In einem exemplarischen Ausführungsbeispiel weist die Reaktionszelle bevorzugt eine Mehrzahl (z.B. zwanzig) Elektrolyse-Module auf, in welchen elementares Metall (z.B. Kupfer) an einer Kathode abgeschieden wird. Bei dieser Reaktion kommt es zur Oxidation von Fremdmetall (des Elektrolyten), welches chemisch unedler als das abzuscheidende Metall ist. In einem Beispiel kann das Rückgewinnen als eine Abfolge von elektrolytischen Bädern realisiert werden. Das Rückgewinnen kann hierbei kontinuierlich oder diskontinuierlich (Batch-weise) durchgeführt werden.

Im Rahmen dieses Dokuments kann unter dem Begriff "Galvanisierungsprozess" insbesondere ein Prozess innerhalb einer Leiterplatten- und/oder Substrat-Herstellung verstanden werden, bei welchem ein Galvanisieren (englisch: plating) durchgeführt wird. Unter "Galvanisieren" bzw. "Galvanik" kann man die elektrochemische Abscheidung metallischer Niederschläge auf Vorrichtungen bezeichnen. Als Vorrichtung dient eine Leiterplatte und/oder ein Substrat, auf welcher der metallische Niederschlag (z.B. Kupfer) z.B. als elektrisch leitfähige Schichtstruktur bzw. Leiterbahn dienen kann. Ferner können z.B. Löcher (Vias) elektrisch leitfähig gemacht werden, indem diese seitlich galvanisiert werden oder mittels Galvanisierung komplett gefüllt werden. In einem Beispiel wird an einem elektrolytischen Bad ein Strom angelegt. Am Pluspol (Anode) befindet sich das Metall, das aufgebracht werden soll (z.B. Kupfer oder Nickel), am Minuspol (Kathode) der zu beschichtende Gegenstand (z.B. eine Leiterplatte). Mittels des elektrischen Stroms lagern sich die Metallionen durch Reduktion auf dem Gegenstand ab. In einem Beispiel kann dieser Prozess als eine Abfolge von elektrolytischen Bädern realisiert werden. Der Galvanisierungsprozess kann hierbei kontinuierlich oder diskontinuierlich (Batch-weise) durchgeführt werden. Gewöhnlich fällt bei diesem Prozess eine Menge Metallsalz-haltigen Mediums als Abfallkonzentrat ("Bleed") an. Dieses enthält generell Prozess-bedingt Fremdmetall und einen hohen Säureanteil, so dass ein Recycling des Metalls (des Metallsalzes) bislang nicht in wirtschaftlicher Weise ermöglicht ist.

Im Rahmen dieses Dokuments kann unter dem Begriff "Prozesskontrollvorrichtung" insbesondere jegliche Vorrichtung (oder Mehrzahl an Vorrichtungen) verstanden werden, welche geeignet ist eine Prozesskontrolle vorzunehmen, wobei der Prozess (zumindest teilweise) eine Leiterplattenund/oder Substrat-Herstellung betrifft. Insbesondere ist die Prozesskontrollvorrichtung eingerichtet (zumindest teilweise) einen Wertstoffkreislauf zu steuern bzw. zu regeln, bei welchem Rückstände der Produktion derart rückgeführt werden, dass im Wesentlichen keine (Schwermetall und/oder Säure) Abfälle anfallen. Die Prozesskontrollvorrichtung kann hierfür insbesondere eine Datenbank (-Einheit) und eine Datenmodell-Einheit aufweisen, wobei erstere ermittelte Prozessdaten speichert, während letztere vorgesehene, erwünschte Prozessdaten speichert. Die Prozesskontrollvorrichtung kann mit einer Vielzahl von Sensoren bzw. Messgeräten gekoppelt sein, um auf diese Weise an verschiedenen Prozessstationen aktuelle Parameter zu bestimmen. Ferner kann die Prozesskontrollvorrichtung eine Berechnungsvorrichtung aufweisen, welche die ermittelten Parameter mit den erwünschten vergleicht und basierend hierauf eine Steueroperation bestimmt und durchführt. In einem bevorzugten Ausführungsbeispiel weist die Prozesskontrollvorrichtung einen selbstlernenden Algorithmus (AI) auf, mittels welchem das Steuern bzw. das Regeln des Prozesses stetig verbessert werden kann.

Im Rahmen dieses Dokuments kann der Begriff "im Wesentlichen" derart ausgelegt werden, dass vernachlässigbare Rückstände bzw. Verschmutzungen umfasst sein können, welche nicht mehr über vertretbaren Aufwand entfernbar sind. Diese vernachlässigbaren Rückstände bzw. Verschmutzungen sind in einem Ausführungsbeispiel (bewusst) nicht erwünscht, lassen sich aber auch mit vernünftigem Aufwand nicht mehr entfernen. Beispielsweise kann ein Medium in Einleitqualität im Wesentlichen frei von Schwermetall sein, was derart verstanden werden soll, dass vernachlässigbare Rückstände bzw. Verschmutzungen (z.B. im unteren Prozent-, Promille-, oder sogar ppm-Bereich) vorhanden sein können. Der Fachmann versteht, dass, obwohl diese Rückstände bzw. Verschmutzungen nicht erwünscht sind, sie aber nicht mehr auf Aufwand-technisch vertretbare Weise separiert werden können.

Im Kontext des vorliegenden Dokuments kann der Begriff "(gedruckte) Leiterplatte" (PCB) insbesondere einen im Wesentlichen plattenförmigen Komponententräger (dieser kann flexibel, rigide, oder semi-flexibel sein) bezeichnen, welcher gebildet wird, indem mehrere elektrisch leitfähige Schichtstrukturen mit mehreren elektrisch isolierenden Schichtstrukturen laminiert werden, beispielsweise indem Druck angelegt wird und/oder indem thermische Energie zugeführt wird. Als bevorzugte Materialien für die PCB Technologie sind die elektrisch leitfähigen Schichtstrukturen aus Kupfer, wohingegen die elektrisch isolierenden Schichtstrukturen Harz und/oder Glasfasern aufweisen können, sogenanntes Prepreg oder FR4 Material. Die verschiedenen elektrisch leitfähigen Schichtstrukturen können miteinander auf gewünschte Weise verbunden werden, indem Durchgangsöffnungen durch das Laminat gebildet werden, beispielsweise mittels Laserbohrens oder mechanischen Bohrens, und indem diese mit elektrisch leitfähigem Material (insbesondere Kupfer) gefüllt werden, wobei dadurch Vias als Durchgangsöffnung Verbindungen gebildet werden. Neben einer oder mehreren Komponenten, welche in eine gedruckte Leiterplatte eingebettet sein können, ist eine gedruckte Leiterplatte typischerweise konfiguriert zum Aufnehmen von einer oder mehreren Komponenten auf einer oder beiden entgegengesetzten Oberflächen der plattenförmigen gedruckten Leiterplatte. Sie können mit der entsprechenden Hauptoberfläche mittels Lötens verbunden werden. Auch können diese Komponenten eingebettet werden. Ein dielektrischer Teil einer PCB kann Harz mit verstärkenden Strukturen (beispielsweise Glasfasern oder Glaskugeln) umfassen.

Im Kontext des vorliegenden Dokuments kann der Begriff "Substrat" insbesondere einen kleinen Komponententräger bezeichnen, welcher im Wesentlichen dieselbe Größe wie eine Komponente hat (insbesondere einer elektronischen Komponente), welche darauf zu montieren ist (wie bei einem Chip Scale Package (CSP)). Insbesondere kann unter einem Substrat ein Träger für elektrische Verbindungen oder elektrische Netzwerke oder auch ein Komponententräger verstanden werden, welcher mit einer gedruckten Leiterplatte (PCB) vergleichbar ist, allerdings mit einer beträchtlich höheren Dichte von seitlich und/oder vertikal angeordneten Verbindungen. Seitliche Verbindungen sind beispielsweise leitfähige Pfade, wohingegen vertikale Verbindungen beispielsweise Bohrlöcher sein können. Diese seitlichen und/oder vertikalen Verbindungen sind in dem Substrat angeordnet und können verwendet werden, um elektrische und/oder mechanische Verbindungen von gehäusten Komponenten oder ungehäusten Komponenten (beispielsweise Dies) bereitzustellen, insbesondere von IC Chips mit einer gedruckten Leiterplatte oder einer Zwischen-gedruckten Leiterplatte. Somit enthält der Begriff "Substrat" auch "IC Substrate". Ein dielektrischer Teil eines Substrats kann Harz mit verstärkenden Partikeln (beispielsweise verstärkende Kugeln, insbesondere Glaskugeln) umfassen.

Das Substrat oder der Interposer kann aus zumindest einer Glas-Schicht (Silizium (Si)) oder einer fotostrukturierbaren, oder einer trockenätzbaren organischen Schicht bestehen. Als organisches Material/organische Schicht kann beispielsweise ein Epoxid-basiertes Aufbaumaterial (beispielsweise Epoxidbasierter Aufbaufolie) oder Polymerverbindungen wie Polyimid, Polybenzoxazol oder Benzocyclobuten-funktionalisierten Polymeren herangezogen werden.

In einer Ausführungsform ist der Komponententräger ein Laminat-Typ Komponententräger. In einer derartigen Ausführungsform ist der Komponententräger ein Verbund aus mehreren Schichtstrukturen, welche gestapelt sind und miteinander verbunden sind, indem eine Presskraft und/oder Wärme aufgebracht wird.

In einer Ausführungsform weist zumindest eine der elektrisch leitfähigen Schichtstrukturen zumindest eines aus der Gruppe auf bestehend aus Kupfer, Aluminium, Nickel, Silber, Gold, Palladium, Magnesium, und Wolfram. Obwohl Kupfer typischerweise bevorzugt ist, sind auch andere Materialien oder beschichtete Versionen davon möglich, insbesondere beschichtet mit einem supra-leitfähigen Material wie beispielsweise Graphen.

In diesem Dokument kann unter dem Begriff "Schwermetall" insbesondere ein Metall verstanden werden, welches eine Dichte größer als 5,0 g/cm³ (alternativ größer als 4,5 g/cm³) aufweist. Hierzu zählen z.B. Kupfer, Nickel, Cobalt, Gold, Silber, Palladium, Wolfram, Zinn, Zink, Eisen, Blei, Chrom, Rhodium, Cadmium, etc. Nicht als Schwermetall bezeichnet werden nach dieser Definition z.B. Aluminium, Silizium, Natrium, Kalium, Calcium, Magnesium, etc.

In diesem Dokument kann unter dem Begriff "Ätzprozess" insbesondere ein Prozess der Leiterplatten- und/oder Substrat-Herstellung bezeichnet werden, welcher das Ätzen von Metall, insbesondere Kupfer, aufweist, um dadurch eine erwünschte metallische (elektrisch leitfähige) Struktur bereitzustellen. Gemäß einem exemplarischen Ausführungsbeispiel kann dieser Prozess wie folgt durchgeführt werden: ein Fotolack schützt Kupferpfade, die nicht weggeätzt werden sollen, während Kupferflächen, welche weggeätzt werden sollen, nicht mit dem Fotolack bedeckt sind. Zunächst wird hierzu die gesamte Kupferlage mit Fotolack überzogen. Dann wird durch eine Maske hinweg der Fotolack mittels UV-Licht entwickelt. Die Maske lässt nur an Stellen UV-Licht durch, an welchen der Fotolack bestehen bleiben soll (i.e. wo die erwünschten Leiterzüge bereitgestellt werden sollen). Während des Entwickelns vernetzt der Lack (bzw. das Polymer) an diesen Stellen, die mit UV-Licht belichtet wurden. Nach dem Entwickeln kann der Fotolack, welcher nicht belichtet wurde (bzw. nicht entwickelt wurde) einfach herunter gewaschen werden. Anschließend wird das Panel (bzw. die Komponententräger Vorform) geätzt. Der Fotolack schützt dabei die Leiterzüge während das Kupfer, das nicht mit Fotolack bedeckt ist, geätzt/entfernt wird. Wenn der Ätzvorgang vorüber ist, wird der Fotolack entfernt bzw. abgezogen (der Lack ist vernetzt und fest) und die Leiterbahnen bleiben übrig. Der gestrippte Fotolack kann zu einem späteren Zeitpunkt mittels Eisenchlorid gefällt werden.

Gemäß einem exemplarischen Ausführungsbeispiel kann die Erfindung auf der Idee basieren, dass ein kostengünstiges, umweltfreundliches, und nachhaltiges Rückgewinnen eines elementaren Metalls aus einem Metallsalz-haltigen Medium (welches neben dem rückzugewinnenden edlen Metall ein unerwünschtes unedles Fremdmetall aufweist) der Leiterplatten- und/oder Substrat-Herstellung auf effiziente und robuste Weise (innerhalb eines Wertstoffkreislaufs) ermöglicht ist, wenn das Metallsalz-haltige Medium einer Reaktionszelle zugeführt wird, in welcher das Metall reduziert und das Fremdmetall oxidiert wird.

Konventionell werden Abfallkonzentrate und Spülwässer aus der Leiterplattenund/oder Substrat-Herstellung auf kostenintensive und wenig umweltfreundliche bzw. nachhaltige Weise entsorgt. Dies auch deswegen, weil Fremdmetalle wie Eisen eine qualitativ hochwertige Rückgewinnung stören oder verunmöglichen. Ferner sind diese Medien gewöhnlich sehr sauer und damit prädestiniert dafür als Sondermüll aufwendig entsorgt zu werden. Eine (zwingend notwendige) qualitativ hochwertige Rückgewinnung erscheint daher nicht auf Kosten-effiziente Weise ermöglicht.

Es wurde nun aber überraschend erkannt, dass ein wirtschaftliches Rückgewinnen von elementarem Metall aus einem Fremdmetall- und Metallsalz-haltigen Medium ermöglicht ist, wenn das Fremdmetall oxidiert wird. Beispielsweise kann dieses Rückgewinnen im Rahmen einer Elektrolyse durchgeführt werden. Innerhalb der Reaktionszelle kann es zu einem Reduzieren (und Abscheidens) des erwünschten Metalls an einer Kathode kommen (von welcher das elementare Metall dann rückgewonnen werden kann), während das Fremdmetall oxidiert wird. Das Oxidieren kann hierbei insbesondere den Vorteil haben, dass ein besonderes effizientes Abtrennen des Fremdmetalls aus dem Metallsalz-haltigen Medium ermöglicht ist, z.B. mittels eines Ionentauschers (welcher oxidierte Metalle deutlich effizienter absorbieren kann). Dieses abgetrennte Fremdmetall kann also selbst rückgewonnen werden und in verschiedenen Prozessschritten weiterverwendet werden (z.B. zur Produktion von Eisenchlorid mit welchem dann Fotolack gefällt werden kann). Ferner kann das Vorliegen eines besonders sauren (z.B. hohe Konzentration an Schwefelsäure aus den Prozessen der Leiterplatten- und/oder Substrat-Herstellung) Metallsalz-haltigen Mediums den Vorteil bringen, dass dieses direkt als Elektrolyt einer Elektrolyse zugeführt werden kann. In bevorzugten Ausführungsbeispielen kann das Rückgewinnen kontinuierlich durchgeführt werden, so dass anfallende Abfälle aus den verschiedenen Prozessschritten ständig aufbereitet werden können, und die Recyclate direkt wieder den Prozessschritten bereitgestellt werden können.

Vorteilhafterweise wird das Rückgewinnen derart durchgeführt, dass die hohe Säurekonzentration nicht etwa störend wirkt, sondern, dass die Säure selbst als Teil des Aufbereitungsprozesses in dem Wertstoffkreislauf gehalten wird und (z.B. über eine Spülwasseraufbereitung oder direkt in einen Säureprozess) in einem Abtrennstrom rückgeführt wird.

Während Metallsalz-haltige Medien aus der Leiterplatten- und/oder Substrat-Herstellung also bislang aufgrund der hohen Konzentration an Fremdmetall und Säure als aufwendig zu entsorgendes Abfallprodukt angesehen wurden, wird nun in völligem Gegensatz hierzu beschrieben, dass ein wirtschaftliches, effizientes Rückführen von Metall, Fremdmetall, und Säure innerhalb ein und desselben Produktionsprozesses ermöglicht ist.

Gemäß einem Ausführungsbeispiel weist das Metall zumindest ein Metall aus der Gruppe auf, welche besteht aus: Kupfer, Nickel, Cobalt, Palladium, Rhodium, Zinn, Cadmium, Magnesium, Natrium, Silber, Gold. Dies hat den Vorteil, dass elementare Ausgangsstoffe der Leiterplatten- und/oder Substratherstellung auf effiziente Weise rückgewonnen werden können und entsprechend in einem (im Wesentlichen) geschlossenen Kreislauf verbleiben.

Gemäß einem weiteren Ausführungsbeispiel weist das Metallsalz ein Metallsulfat (insbesondere Kupfersulfat, CuSO₄) auf. Dies kann den Vorteil haben, dass ein Massenprodukt (Metallsulfat) der Leiterplatten-/Substrat-Herstellung (insbesondere Galvanisierung und/oder Ätzprozess) (im Wesentlichen) vollständig recycelt bzw. innerhalb desselben Prozesses rückgeführt werden kann.

Gemäß einem weiteren Ausführungsbeispiel weist das Fremdmetall zumindest eines aus der Gruppe auf, welche besteht aus: Eisen, Blei, Zinn, Molybdän, Nickel, Kobalt, Indium, Cadmium, Zink, Chrom, Natrium, Palladium. Insbesondere weist das Oxidieren die Reaktion von Fe²⁺ zu Fe³⁺ auf. Dies kann den Vorteil haben, dass Metalle, welche zunächst als störend angesehen werden, in abgetrennter (separierter) Form wieder zu interessanten Rohstoffen werden. Somit kann ein Abwasser (bzw. Elektrolyt) aus der Rückgewinnung von Metall umfunktioniert werden in ein Rohstofflager wirtschaftlich bedeutender Metalle. In einem Ausführungsbeispiel liegt das Fremdmetall (zumindest teilweise) als Fremdmetallsalz vor.

Gemäß einem weiteren Ausführungsbeispiel findet das Oxidieren in der Reaktionszelle statt. Dies insbesondere während der Elektrolyse. Dies kann einerseits den Vorteil haben, dass das Rückgewinnen des Metalls besonders effizient durchgeführt werden kann. Weiterhin kann das Oxidieren des Fremdmetalls den Vorteil haben, dass dieses unter Einsparen eines zusätzlichen Oxidations-Schrittes besonders effizient (aus dem Elektrolyten) abgetrennt (und ebenfalls rückgewonnen) werden kann. Beispielsweise im Falle von Eisen hat sich überraschend gezeigt, dass Fe³⁺ an einem Ionentauschharz wesentlich besser adsorbiert wird als Fe²⁺ (wenn z.B. ein Ionentauscher verwendet wird, um das Fremdmetall aus dem Elektrolyten abzutrennen bzw. rückzugewinnen). Ansonsten müsste das Oxidieren mittels eines zusätzlichen Oxidationsmittels (z.B. Wasserstoffperoxid, Kaliumpermanganat) durchgeführt werden, welches neben zusätzlichem Aufwand auch Rückstände im Medium verursachen könnte.

Gemäß einem weiteren Ausführungsbeispiel weist das Verfahren auf: kontinuierliches Zuführen von Metallsalz-haltigem Medium zu der Reaktionszelle. Dies kann den Vorteil haben, dass das Rückgewinnen kontinuierlich betrieben werden kann. Auf diese Weise kann das Recycling (und Rückführen innerhalb des Wertstoffkreislaufs) parallel zu der Leiterplatten-/Substrat-Herstellung betrieben werden, so dass immer rückgewonnenes Metall bereitsteht und (im Wesentlichen) nicht ausschließlich neu zugeführt werden muss. Zusammen mit dem Rückgewinnen des elementaren Metalls können weitere Rückgewinn-Verfahren kontinuierlich betrieben werden, wie z.B. Rückgewinnen von abgetrenntem Fremdmetall und Rückgewinnen von abgetrennter Säure. Dadurch kann die (gesamte) Leiterplatten- und/oder Substrat-Herstellung mit allen Teilund Abtrennströmen kontinuierlich und zeitgleich betrieben werden.

Wie im Folgenden beschrieben wird, kann das kontinuierliche Betreiben dadurch realisiert werden, dass (ständig) Elektrolyt abgezweigt und aufgereinigt (bzw. nachgeregelt) wird. Zusätzlich oder alternativ kann das kontinuierliche Aufreinigen (bzw. Nachregeln) der Elektrolyt Zusammensetzung mittels eines Versorgungsbeckens geschehen.

Gemäß einem weiteren Ausführungsbeispiel weist das Verfahren auf: Einstellen (insbesondere selektives Einstellen) der Zusammensetzung des Metallsalz-haltigen Mediums. Insbesondere kann das Einstellen ein kontinuierlich durchgeführtes Regeln aufweisen. Dies kann den Vorteil haben, dass das Metallsalz-haltige Medium immer mit einer bekannten und erwünschten Zusammensetzung (bzw. mit bekannten und erwünschten Eigenschaften) dem Rückgewinnen zugeführt werden kann und/oder innerhalb des Rückgewinnens mit einer bekannten und erwünschten Zusammensetzung (bzw. mit bekannten und erwünschten Eigenschaften) vorliegt. In diesem Dokument kann der Begriff "Einstellen" sowohl ein Steuern als auch ein Regeln bezeichnen. Beispielsweise kann die Zusammensetzung selektiv gesteuert werden. Ferner kann die Zusammensetzung (bevorzugt kontinuierlich) nachgeregelt werden.

Gemäß einem weiteren Ausführungsbeispiel erfolgt das Einstellen von einem Versorgungsbecken (insbesondere einem Harmonisierungsbecken) ausgehend, welches der Reaktionszelle in Prozessrichtung vorgeschaltet ist. Gemäß einem weiteren Ausführungsbeispiel stehen das Versorgungsbecken und die Reaktionszelle in Fluidkommunikation (insbesondere kontinuierlich) miteinander. Dies kann den Vorteil haben, dass ein besonders effizientes Einstellen realisiert werden kann, ohne dass die chemische Reaktion während dem Rückgewinnen gestört wird.

In einem Ausführungsbeispiel wird der (Gesamt-) Strom mit dem Metallsalz-haltigen Medium in ein Versorgungsbecken bzw. Harmonisierungsbecken geleitet, welches mit der Reaktionszelle in (beidseitiger) Fluidkommunikation verbunden ist. Das Versorgungsbecken kann vorteilhaft verwendet werden, um die Zusammensetzung des Metallsalz-haltigen Mediums (welches auch den Elektrolyten (für die Elektrolyse) in der Reaktionszelle darstellt) zu regeln. Bevorzugt wird das Verfahren zum Rückgewinnen kontinuierlich betrieben, so dass das Versorgungsbecken in vorteilhafter Weise eine gewünschte Zusammensetzung des Elektrolyten regelt. Somit wird die Elektrolyse nicht gestört, während aber der Elektrolyt ständig nachgeregelt werden kann.

Gemäß einem weiteren Ausführungsbeispiel erfolgt das Einstellen zusätzlich oder alternativ zu dem Versorgungsbecken direkt von der Reaktionszelle aus. Dies kann den Vorteil haben, dass Platz und Aufwand gespart werden können.

Gemäß einem weiteren Ausführungsbeispiel kann das Einstellen (insbesondere kontinuierliche Regeln) der Zusammensetzung des Elektrolyten (Metallsalz-haltigen Mediums) (von dem Versorgungsbecken und/oder von der Reaktionszelle ausgehend) z.B. folgende Schritte umfassen: i) Filtern von organischen Bestandteilen mittels eines Filters, bevorzugt eines Aktivkohlefilters, aus dem Metallsalz-haltigen Medium (dem Elektrolyten), ii) Separieren des oxidierten Fremdmetalls aus dem Metallsalz-haltigen Medium (dem Elektrolyten) mittels eines Ionentauschers, und iii) Separieren von Säure (insbesondere Schwefelsäure) aus dem Metallsalz-haltigen Medium (dem Elektrolyten). Dies ermöglicht ein selektives Einstellen (Nachregeln), wobei die abgetrennten Stoffe zumindest teilweise Verfahrens-intern weiterverwendet werden.

Gemäß einem weiteren Ausführungsbeispiel weist das Verfahren, insbesondere das Einstellen, auf: Regeln der Temperatur. Dies insbesondere in dem Bereich 40°C bis 70°C, insbesondere 45°C bis 65°C. Dadurch kann sich der Vorteil ergeben, dass eine besonders günstige Temperatur zum Durchführen des Rückgewinnens (insbesondere der Elektrolyse) bereitgestellt ist.

Gemäß einem weiteren Ausführungsbeispiel weist das Verfahren, insbesondere das Einstellen, auf: Aufkonzentrieren des Metallsalzes in dem Metallsalz-haltigen Medium (insbesondere mittels eines Verdunsters, z.B. eines Verdunsterturms). Dies kann den Vorteil haben, dass ein hoch-konzentriertes Medium dem Rückgewinnen zugeführt werden kann, wodurch sich der Prozess noch effizienter gestalten lässt. Ferner kann das Verdunsten auch während des Rückgewinnens (bzw. der Elektrolyse) stattfinden, z.B. an abgezweigtem Elektrolyt.

Gemäß einem weiteren Ausführungsbeispiel weist das Verfahren, insbesondere das Einstellen, auf: Separieren des (insbesondere oxidierten) Fremdmetalls aus dem Metallsalz-haltigen Medium. Dies kann den Vorteil haben, dass das Metallsalz-haltige Medium als Elektrolyt aufgereinigt wird, während das Fremdmetall als Rohstoff für andere Prozessschritte gewonnen wird.

Gemäß einem weiteren Ausführungsbeispiel weist das Verfahren ferner auf: (zumindest teilweises) Separieren des (insbesondere oxidierten) Fremdmetalls mittels eines Ionentauschers. Insbesondere eines Ionentauschers, welcher ein selektives Ionenaustauschharz, weiter insbesondere ein doppel-funktionalisiertes Ionenaustauschharz, aufweist. Dies kann den Vorteil haben, dass ein besonders effizientes Abtrennen des Fremdmetalls ermöglicht ist.

Im Rahmen dieses Dokuments kann unter dem Begriff "Ionentauscher" insbesondere Materialien (bzw. Vorrichtungen) umfassen, mit denen gelöste Ionen durch andere Ionen gleicher Ladung (positiv oder negativ) ersetzt werden können. Ionentauscher können z.B. als Säulen, die mit einem Ionenaustauschmaterial gefüllt sind, oder als Membranen realisiert werden, welche mit einer Lösung durchströmt werden. Die auszutauschenden Ionen werden am Ionenaustauschmaterial gebunden bzw. adsorbiert. In einem Beispiel weist ein Ionentauscher ein selektives Ionenaustauschharz, weiter insbesondere ein doppel-funktionalisiertes Ionenaustauschharz, auf.

In einem Ausführungsbeispiel weist das Trägermaterial des Ionenaustauschharzes des Ionentauscher Polystyrol auf. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Fremdmetall leichter vom Harz desorbiert werden.

In einem Ausführungsbeispiel hat es sich überraschend herausgestellt, dass gerade das Verwenden eines speziellen Ionenaustauschharzes mit zwei funktionellen Gruppen eine (effiziente) Desorption des Metalls (z.B. Kupfer) ermöglicht. Dies ist insbesondere deswegen beachtenswert, weil Ionenaustauschharze (insbesondere einfach-funktionalisierte) teilweise zu einer irreversiblen Adsorption des Metalls neigen (insbesondere bei Fe³⁺ hat sich herausgestellt, dass generell eine irreversible Adsorption stattfindet).

In einem exemplarischen Beispiel ist der Ionenaustauscher zweistufig aufgebaut. Der nachgeschaltete (zweite) Ionenaustauscher nimmt den Metallrest des vorangeschalteten (zu beladenden) Ionenaustauschers auf. Weist der erste Ionentauscher einen erhöhten Metallrest auf, kann dieser regeneriert und anschließend an die nachgeschaltete (zweite) Stelle geschaltet werden.

Gemäß einem weiteren Ausführungsbeispiel weist das Verfahren ferner auf: i) Beladen des Ionentauschers mit dem Metallsalz-haltigen Medium (bzw. Elektrolyten), in welchem das Fremdmetall oxidiert vorliegt, derart, dass das Fremdmetall an dem Ionentauscher verbleibt (insbesondere adsorbiert), und nachfolgend ii) Regenerieren des Ionentauschers mittels Strömens einer sauren Lösung durch den Ionentauscher derart, dass das Fremdmetall in der sauren Lösung gelöst wird und eine Fremdmetall-haltige saure Lösung als Regenerat bereitgestellt wird. Dies kann einerseits den Vorteil bereitstellen, dass Medium (insbesondere saures flüssiges Medium, welches in hohen Volumina auftreten kann) eingespart werden kann. Andererseits und zeitgleich kann sich der Vorteil ergeben, dass innerhalb des Regenerats ein Aufkonzentrieren stattfindet.

Im Rahmen dieses Dokuments kann unter dem Begriff "Regenerieren" insbesondere verstanden werden, dass ein (selektiver) Ionentauscher von einem ersten Betriebszustand in einen zweiten Betriebszustand überführt wird. Insbesondere ist in dem ersten Betriebszustand ein Metall (insbesondere ein Kation) an dem Ionentauscher (bzw. Ionentauschharz) adsorbiert. Weiter insbesondere ist in dem zweiten Betriebszustand das Metall im Wesentlichen desorbiert. In diesem zweiten Betriebszustand kann der Ionentauscher also wieder betriebsbereit sein, um Beladen zu werden und entsprechend wieder den ersten Betriebszustand einzunehmen. Ein Regenerieren kann vorteilhaft vielfach wiederholt werden. In einem Beispiel wird das Regenerieren mittels eines Regeneriermediums durchgeführt, insbesondere einer Regeneriersäure wie Schwefelsäure und/oder Salzsäure. Bei einem Regenerieren kann das Regeneriermedium adsorbiertes Metall desorbieren. Nach einem Aufreinigen kann das Regeneriermedium erneut verwendet werden. In einem weiteren Beispiel muss das Regeneriermedium nicht aufgereinigt werden, so dass sich die Metallkonzentration in dem Regeneriermedium mit jedem (Regenerier-) Durchlauf durch den Ionentauscher weiter erhöht. Auf diese Weise kann ein "Regenerieren" in diesem Dokument auch ein Aufkonzentrieren eines rückzugewinnenden (Fremd-) Metalls sein.

Gemäß einem weiteren Ausführungsbeispiel weist das Regenerieren ferner auf: Verwenden des Regenerats (zumindest teilweise) als weiteres Regeneriermedium für einen oder mehr weitere Regenerierschritte in dem Ionentauscher. Insbesondere steigt die Konzentration des Fremdmetalls in dem Regenerat mit jedem Regenerierschritt an, so dass ein konzentriertes Regenerat vorliegt. Gleichzeitig nimmt die Säurekonzentration ab, da die Protonen der Säure am Ionentauscher verbleiben. Aus diesem Grund kann mit einer hohen Säurekonzentration gestartet werden. Dies kann den Vorteil haben, dass Material gespart werden kann, während zugleich eine Aufkonzentrierung in dem Regenerat stattfindet und Abfall reduziert wird.

Gemäß einem weiteren Ausführungsbeispiel weist das Verfahren ferner auf: Bereitstellen der Fremdmetall-haltigen sauren Lösung an einen weiteren Prozess bei der Herstellung gedruckter Leiterplatten (insbesondere einen Prozess zum Fällen von Fotolack). Dies kann den Vorteil haben, dass (insbesondere auf kontinuierliche Weise) ohne Zusatzaufwand eine Produktion ohnehin für die Leiterplatten- und/oder Substrat-Herstellung benötigter Substanzen, wie z.B. Eisenchlorid, bereitgestellt ist.

Gemäß einem weiteren Ausführungsbeispiel weist das Fremdmetall Eisen auf, die saure Lösung weist Salzsäure, HCl, auf, und die Fremdmetall-haltige saure Lösung weist Eisenchlorid, FeCl₃, auf. In diesem exemplarischen Ausführungsbeispiel weist die Fremdmetall-haltige saure Lösung Eisenchlorid auf (Eisen und Salzsäure). In diesem Sinne kann also das Aufbereiten einer Fremdmetall-haltigen sauren Lösung aus einem Rückgewinnungsprozess von elementarem Metall der Leiterplatten- und/oder Substrat-Herstellung als Ausgangsmaterial verwendet werden zur (bevorzugt kontinuierlichen) Produktion von Eisenchlorid für das Fällen von Polymer-basierten Fotolacken für die gedruckten Leiterplatten und/oder Substrate.

In einem Beispiel bestehen Fotolacke generell aus photo-aktiven Initiatoren und einem Harz, wobei das Harz ein funktionalisiertes Polymer oder ein Copolymer sein kann. Harze für Positivlacke sind z.B. Lacke oder Phenol-Formaldehydbasierte Polymere wie Novolac. Als Photoinitiator kann z.B. Diazonaphthoquinon (Mischung: DNQ-Novolac) verwendet werden. Harze für Negativlacke umfassen z.B. Harze auf Epoxid-Basis. Ferner gibt es auch Trockenlacke, welche z.B. auf Polyacrylaten basieren. In einem Ausführungsbeispiel lassen sich Trockenlacke besonders effizient fällen.

Gemäß einem weiteren Ausführungsbeispiel weist das Verfahren, insbesondere das Einstellen, ferner auf: Separieren von Säure, insbesondere Schwefelsäure, aus dem Metallsalz-haltigen Medium. Gemäß einem weiteren Ausführungsbeispiel weist das Separieren der Säure auf: Durchführen einer Membrandialyse (bzw. Säuredialyse), um ein Dialysat, welches das Metallsalz aufweist, und ein Diffusat, welches die Säure aufweist, zu erhalten. Dies kann einerseits den Vorteil bereitstellen, dass ein Säureüberschuss aus dem Elektrolyten (kontinuierlich) entfernt wird, zugleich kann abgetrennte Säure wieder in verschiedene Prozessschritte als Abtrennstrom rückgeführt werden.

Im Rahmen dieses Dokuments kann unter dem Begriff "Dialyse" insbesondere verstanden werden, dass ein konzentrationsgetriebener Membranprozess verwendet wird, um Moleküle (insbesondere Ionen) aus einer Lösung zu entfernen. In einem Ausführungsbeispiel wird ein Metallsalz-haltiges Medium über einen ersten Zulauf an eine erste Seite der Membran bereitgestellt und über einen zweiten Zulauf wird ein weiteres Medium (z.B. Wasser) an der zweiten (der ersten gegenüberliegenden) Seite der Membran bereitgestellt. Die Membran kann semipermeabel sein und lässt Anionen (z.B. Chlorid, Sulfat) passieren (Anionen-Membran), während Kationen (z.B. Cu²⁺) nicht passieren können. Somit konzentrieren sich Kationen in dem Metallsalz-haltigen Medium als Dialysat, während sich Anionen in dem weiteren Medium als Diffusat konzentrieren. In dem Beispiel von Chlorid- (bzw. Sulfat-) Anionen wird das Diffusat stark sauer, so dass auch der Begriff "Säuredialyse" verwendet werden kann.

In einem Ausführungsbeispiel entsteht während der Elektrolyse Schwefelsäure, welche vom Elektrolyten abgetrennt werden muss, um die gewünschte Abscheiderate des Metalls erhalten zu können. Mit steigender Schwefelsäurekonzentration nimmt die Menge an abzuscheidendem Metall ab. Durch das Separieren wird das Metallsalz-haltige Medium mit einer deutlich geringeren Säure-Konzentration als Dialysat erhalten, während das Diffusat eine hohe Säure-Konzentration (insbesondere Schwefelsäure) aufweist. Das Säure-haltige Diffusat wird z.B. im Zuge eines dritten Abtrennstroms an das Verfahren zum Aufbereiten von Spülwasser aus der Leiterplatten- und/oder Substrat-Herstellung bereitgestellt bzw. rückgeführt.

Gemäß einem weiteren Ausführungsbeispiel weist ein Zulauf des Diffusats der Membrandialyse ein Lösungsmittel, insbesondere entsalztes Wasser, auf. Dies kann den Vorteil haben, dass ein besonders Kosten-günstiges Abtrennen von Säure durchgeführt werden kann.

Gemäß einem weiteren Ausführungsbeispiel hat die Membrandialyse einen Durchsatz in dem Bereich 0,5 bis 5 L/hm², insbesondere 1 bis 2 L/hm². Gemäß einem weiteren Ausführungsbeispiel weist zumindest eine Membran der Membrandialyse eine Wickelmembran oder eine Plattenmembran auf. Dies kann den Vorteil haben, dass etablierte und bewährte Prozesse direkt implementiert werden können.

Es kann für die beschriebenen Membrandialysen jeweils dieselbe Membran eingesetzt werden oder (bevorzugt) werden unterschiedliche Membranen verwendet. Eine Anionen-Membran kann z.B. mit Brom (Br⁻) funktionalisiert sein, wobei das Trägermaterial beispielsweise PET oder PVC sein kann. In bestimmten Fällen kann die Metallsalz-haltige Lösung Wasserstoffperoxid (H₂O₂) beinhalten. In diesem Fall kann bevorzugt eine oxidationsbeständige Membran genutzt werden, welche z.B. auf PEEK (Polyetheretherketon-Trägermaterial) basiert.

Gemäß einem weiteren Ausführungsbeispiel weist das Verfahren ferner auf: Bereitstellen des Säure-haltigen Diffusats als dritter Abtrennstrom an ein Verfahren zum Aufbereiten von Spülwasser aus der Leiterplatten- und/oder Substrat-Herstellung. Dies kann den Vorteil haben, dass geringe Konzentrationen des Metallsalzes in dem Säure-Diffusat durch eine effiziente Aufbereitung (aufkonzentriert und) rückgewonnen werden können.

Eine (insbesondere kontinuierliche) Membrandialyse vom Elektrolyten kann ein besonders großes Volumen an Wasser erfordern, was wiederum Maßnahmen wie einen Verdunsterturm benötigt, um die Säure in einer geeigneten Konzentration wieder rückgewinnen zu können. In einem Ausführungsbeispiel wird daher das Betreiben der Elektrolyse nur so lange durchgeführt, bis der Elektrolyt eine definierte Säure- und Kupfer Konzentration (z.B. Cu²⁺ etwa 5 g/L) erreicht hat. Anschließend kann dieser verbrauchte Elektrolyt für die Aufbereitung der Spülwässer herangezogen werden. Dadurch verbleibt das Metall im Wertstoffkreislauf und die Säure muss nicht (kontinuierlich) über eine Dialyse in einem zusätzlichen Prozessschritt abgetrennt werden.

Gemäß einem weiteren Ausführungsbeispiel weist das Verfahren auf: Bereitstellen des Metallsalz-haltigen Mediums mittels zumindest einem aus der Gruppe (von Prozessströmen) zur Leiterplatten- und/oder Substrat-Herstellung, welche besteht aus:
i) einem Metallsalz-haltigen Medium aus einem Ätzprozess über einen ersten Teilstrom, ii) einem Metallsalz-haltigen Medium aus einem Galvanisierungsprozess (insbesondere wobei das Fremdmetall im Wesentlichen aus dem Galvanisierungsprozess stammt) über einen zweiten Teilstrom, iii) einem Metallsalz-haltigen Medium aus dem Verfahren zum Aufbereiten von Spülwasser über einen dritten Teilstrom. Dies kann den Vorteil haben, dass Abfälle bzw. Abfallkonzentrate aus einer Vielzahl von verschiedenen Prozessschritten aus der Leiterplatten- und/oder Substrat-Herstellung (kontinuierlich) im Wesentlichen gemeinsam recycelt werden können.

In einem Ausführungsbeispiel werden die Teilströme gemischt zu einem Gesamtteilstrom, welcher dem Rückgewinnen zugeführt wird. Gemäß einem Ausführungsbeispiel kann der erste Teilstrom (i) auch alleine als Gesamtteilstrom verwendet werden. Dies insbesondere dann, wenn das Metallsalz-haltige Medium des ersten Teilstroms nicht vernachlässigbare Rückstände an aufzubereitendem Metallsalz (z.B. Kupferchlorid) und/oder Säure aufweist. Das Metallsalz-haltige Medium aus dem Galvanisierungsprozess (ii) und das Metallsalz-haltige Medium aus dem Verfahren zum Aufbereiten von Spülwasser (iii) können dann beispielsweise zu einem weiteren Gesamtstrom vermischt werden.

Gemäß einem weiteren Ausführungsbeispiel ist der Ionentauscher der Membrandialyse in Prozessrichtung vorgeschaltet. Dies kann den Vorteil haben, dass Fremdmetall bereits abgetrennt ist, wenn aus dem Metallsalz-haltigen Medium Säure separiert wird. Dadurch kann die Membrandialyse besonders effizient durchgeführt werden.

Gemäß einem weiteren Ausführungsbeispiel ist zumindest eines von dem Ionentauscher, der Membrandialyse, und dem Filter, direkt mit dem Versorgungsbecken in Fluidkommunikation koppelbar. Dies kann den Vorteil haben, dass besonders relevante Aufbereitungsschritte direkt durchgeführt werden können und Elektrolyt mit (nachgeregelten) erwünschten Eigenschaften (kontinuierlich) der Rückgewinnung bereitgestellt werden kann.

Gemäß einem weiteren Ausführungsbeispiel weist die Berechnungsvorrichtung einen selbstlernenden Algorithmus (insbesondere mittels neuronaler Netzwerke) auf zum Vergleichen und/oder zum Bestimmen. Dies kann den Vorteil bereitstellen, dass die Prozesskontrollvorrichtung (zumindest teilweise) selbstständig arbeiten und sich basierend hierauf weiterentwickeln kann. Ein selbstlernender Algorithmus (maschinelles Lernen) kann ein künstliches System sein, welches aus Beispielen (bzw. Anwendungen) lernt und diese (nach oder während einer Lernphase) verallgemeinert. Ein solcher Algorithmus kann z.B. mittels neuronaler Netzwerke realisiert werden.

Gemäß einem weiteren Ausführungsbeispiel i) ist der selbstlernende Algorithmus eingerichtet, die bestimmte Steueroperation automatisch durchzuführen, und/oder ii) der selbstlernende Algorithmus ist eingerichtet die bestimmte Steueroperation einem Benutzer zum Überprüfen bereitzustellen. Dadurch kann sich der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist i) der selbstlernende Algorithmus eingerichtet basierend auf dem Vergleichen einen neuen vorbestimmten Prozessparameter zu bestimmen und automatisch der Datenmodell-Einheit zuzuführen und/oder ii) der selbstlernende Algorithmus ist eingerichtet basierend auf dem Vergleichen einen neuen vorbestimmten Prozessparameter zu bestimmen und dem Benutzer zum Überprüfen bereitzustellen. Dadurch kann sich ebenfalls der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist der selbstlernende Algorithmus eingerichtet, das Ergebnis des Überprüfens durch den Benutzer als Lerngrundlage zu verwenden. Dies kann den Vorteil bereitstellen, dass sich der selbstlernende Algorithmus während dem Betreiben des Verfahrens ständig in einer gewünschten Richtung weiterentwickelt und über die Zeit immer mehr Aufgaben direkt umsetzen kann.

Im Folgenden werden exemplarische Ausführungsbeispiele der vorliegenden Erfindung mit Verweis auf die folgenden Figuren detailliert beschrieben.
Die **Figuren 1 bis 3** zeigen jeweils eine Übersicht der Teilströme beim Herstellen von Leiterplatten und/oder Substraten gemäß Ausführungsbeispielen der Erfindung.
Die **Figuren 4 bis 8** zeigen jeweils ein Rückgewinnen eines elementaren Metalls aus einem Metallsalz-haltigen Medium aus der Leiterplatten- und/oder Substrat-Herstellung gemäß Ausführungsbeispielen der Erfindung.
Die **Figur 9** zeigt eine Übersicht der Aufbereitungsprozesse und des Rückgewinnens bei der Leiterplatten- und/oder Substrat-Herstellung gemäß einem Ausführungsbeispiel der Erfindung.
Die **Figur 10** zeigt eine Prozesskontrollvorrichtung zum Regulieren von zumindest einem Teil des oben beschriebenen Verfahrens (bzw. der Industrieanlage) gemäß einem Ausführungsbeispiel der Erfindung.

Gleiche oder ähnliche Komponenten in unterschiedlichen Figuren sind mit gleichen Bezugsziffern versehen.

Im Folgenden wird ein Prozess beschrieben zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Dieser Prozess ermöglicht es, dass anfallende Rückstände der Leiterplatten- und/oder Substrat-Herstellung in Teilströmen derart in einem Wertstoffkreislauf transportiert und rückgeführt werden können, dass im Betriebszustand des Verfahrens zum Herstellen von Leiterplatten und/oder Substraten als Abfall (im Wesentlichen) letztlich nur ein Medium in Einleitqualität (insbesondere in Kläranlagen oder Gewässer) anfällt.

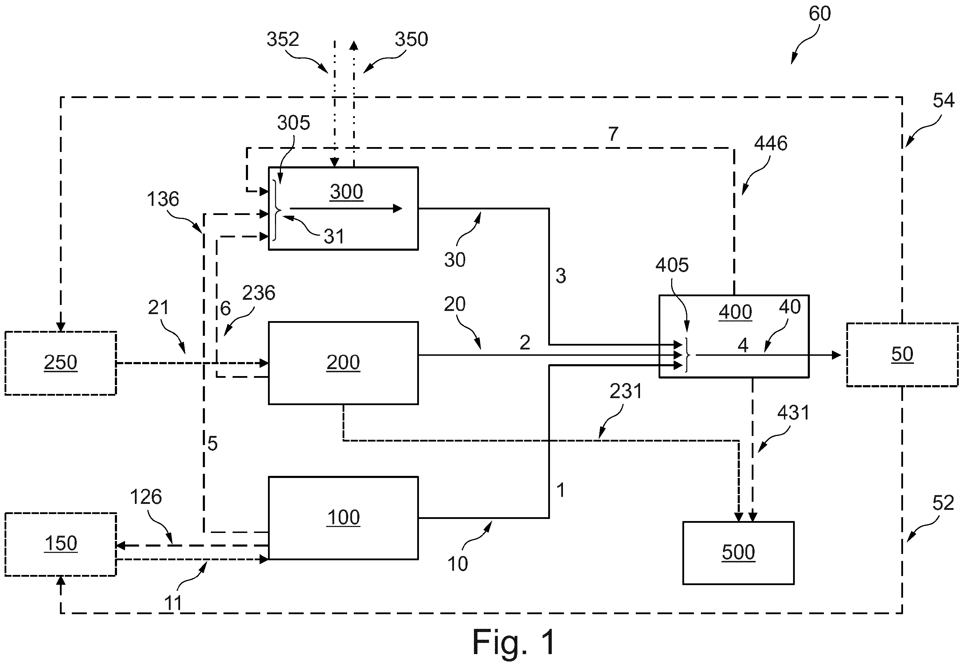

**Figur 1** zeigt eine Übersicht von Strömen 1 bis 7 beim Herstellen von Leiterplatten und/oder Substraten, z.B. in einer Industrieanlage 60, gemäß einem Ausführungsbeispiel der Erfindung. Das Verfahren zum Herstellen von Leiterplatten und/oder Substraten wird derart betrieben, dass die anfallenden Prozess-Rückstände 11, 21, 31 in drei hauptsächlichen Teilströmen 1, 2, 3 (und insbesondere zumindest teilweise als Gesamtstrom 4) und drei hauptsächlichen Abtrennströmen 5, 6, 7 (welche insbesondere Säure-Rückstände aufweisen) derart in einem Wertstoffkreislauf geleitet und rückgeführt (bzw. recycelt) werden, dass in dem (gezeigten) Betriebszustand des Herstellungsverfahrens als Abfall (im Wesentlichen) nur ein Medium 350 in Einleitqualität anfällt. In anderen Worten weist das Medium 350 in Einleitqualität (im Wesentlichen) keine Hauptkomponenten (insbesondere kein Schwermetall) der Leiterplatten/Substrat-Herstellung mehr auf, sondern besteht lediglich aus Wasser, Salzen, und organischem Material. Dem Herstellungsverfahren müssen im (gezeigten) Betriebszustand (im Wesentlichen) also nur Wasser 352 und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Prinzipiell können in dem beschriebenen Wertstoffkreislauf 95% oder mehr, insbesondere 98% oder mehr, der Schwermetall-Rückstände (z.B. Kupfer Rückstände) rückgeführt werden. In einem exemplarischen Beispiel des Wertstoffkreislauf werden mindestens 80% (insbesondere mindestens 85%, weiter insbesondere mindestens 90%) der abgetrennten Salzsäure rückgeführt, und mindestens 70% (insbesondere mindestens 75%, weiter insbesondere mindestens 80%) der benötigten Schwefelsäure Verfahrens-intern produziert. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Die anfallenden Rückstände 11, 21, 31 bzw. Abfallkonzentrate können als aufzubereitende Metallsalz-haltige Medien bezeichnet werden und weisen in einem exemplarischen Ausführungsbeispiel u.a. auf: Kupfer, Kupfersulfat, Kupferchlorid, Eisen, Nickel, Gold, Salzsäure, Schwefelsäure. Die aufzubereitenden Metallsalz-haltigen Medien 11, 21, und 31 werden jeweils in einem entsprechenden Aufbereitungsprozess 100, 200, 300 aufbereitet und dann als Teilströme 1, 2, 3, welche jeweils aufbereitetes Metallsalz-haltiges Medium 10, 20, 30 aufweisen, einem Rückgewinnungsprozess 400 zugeführt. Nach der Aufbereitung schließlich wird rückgewonnenes, elementares Metall 50 wieder in den Herstellungsprozess eingespeist (Pfeile 52 und 54). Im Folgenden wird ein prinzipieller Überblick über die Teilströme 1 bis 7 innerhalb des Wertstoffkreislaufs gegeben. Weiter unten folgen dann detaillierte Beschreibungen der einzelnen Prozesse.

Der erste Teilstrom 1 weist ein erstes aufbereitetes Metallsalz-haltiges Medium 10 aus einem Ätzprozess 150 der Leiterplatten- und/oder Substrat-Herstellung auf, welches in einem ersten Aufbereitungsprozess 100 aufbereitet wird. Das erste aufbereitete Metallsalz-haltige Medium 10 (welches im Wesentlichen kein aufzubereitendes Metallsalz aufweist) wird aus dem aufzubereitenden Medium 11 aus dem Ätzprozess 150 erhalten. Das aufzubereitende Medium 11 weist ein aufzubereitendes Metallsalz (z.B. Kupferchlorid) und eine Säure auf. Das Aufbereiten 100 umfasst ein mehrstufiges Entfernen 110, 120 der Säure mittels Membrandialyse und Durchführen einer chemischen Reaktion 140. Bei der Membrandialyse fällt ein erstes Säure-haltiges Diffusat 136 an. Ein weiteres Säure-haltiges Diffusat 126 kann direkt an den Ätzprozess 150 bereitgestellt werden.

Der zweite Teilstrom 2 weist ein zweites aufbereitetes Metallsalz-haltiges Medium 20 aus einem Galvanisierungsprozess 250 der Leiterplatten- und/oder Substrat-Herstellung auf. Das zweite aufbereitete Metallsalz-haltige Medium 20 (welches im Wesentlichen kein Eisen aufweist) wird aus einem Eisen- und Metallsalz-haltigen Medium 21 aus dem Galvanisierungsprozess 250 erhalten. Das Aufbereiten 200 umfasst ein Separieren des Eisens aus dem Eisen- und Metallsalz-haltigen Medium 21 mittels eines Ionentauschers 220. Bei einem Regenerieren 222 des Ionentauschers 220 fällt ein zweites Säure-haltiges Diffusat 236 an.

Der dritte Teilstrom 3 weist ein drittes aufbereitetes Metallsalz-haltiges Medium 30 aus Spülwasser 32 bzw. einer Spülwasser Mischung 31 der Leiterplattenund/oder Substrat-Herstellung auf. Das dritte aufbereitete Metallsalz-haltige Medium 30 wird in einem dritten Aufbereitungsprozess 300 unter Verwenden eines Ionentauschers 320 erhalten, wobei das Metallsalz in dem aufbereiteten Metallsalz-haltigen Medium 30 im Vergleich zu dem Spülwasser 32 aufkonzentriert ist.

Die Teilströme 1, 2, 3 können (zumindest teilweise) vereint werden (siehe Schritt 405) zu einem Gesamtstrom 4 oder auch einzeln aufbereitet werden. Das Aufbereiten 400 umfasst ein Rückgewinnen 400 des elementaren Metalls 50 (z.B. elementares Kupfer) aus dem Metallsalz-haltigen Medium 40 in einer (Elektrolyse-) Reaktionszelle 450. Das (kontinuierliche) Einstellen der Zusammensetzung des Metallsalz-haltigen Mediums 40 als Elektrolyten umfasst ein Abtrennen 440 von Säure mittels Membrandialyse, wobei ein drittes Säure-haltiges Diffusat 446 anfällt. Alternativ kann das Diffusat 446 auch zur Regeneration eines Ionentauschers 320 zur Aufbereitung der Spülwässer herangezogen werden. Hierbei bleibt das Metall (insbesondere Kupfer) ebenfalls im Wertstoffkreislauf und kann daher nahezu vollständig aus dem Metallsalz-haltigen Medium entfernt werden. Das hat den Vorteil, dass ein weiterer Aufbereitungsschritt mittels Membrandialyse eingespart werden kann. Das erhaltene hochreine Metall 50 wiederum ist geeignet erneut in den Ätzprozess 150 rückgeführt (siehe Pfeil 52) zu werden und/oder in den Galvanisierungsprozess 250 rückgeführt (siehe Pfeil 54) zu werden.

Ein erster Abtrennstrom 5 stammt aus dem ersten Aufbereitungsprozess 100 und weist das erste Säure-haltige Diffusat 136 auf. Ein zweiter Abtrennstrom 6 stammt aus dem zweiten Aufbereitungsprozess 200 und weist das zweite Säure-haltige Diffusat 236 auf. Ein dritter Abtrennstrom 7 stammt aus dem Aufbereitungsprozess 410 des Gesamtstroms 4 und weist das dritte Säure-haltige Diffusat 446 auf. Die Abtrennströme 5, 6, 7 weisen jeweils das Metallsalz (z.B. Kupfersulfat) in geringer Konzentration auf, bzw. in geringerer Konzentration als die Konzentration des Metallsalzes in dem dritten Teilstrom 3. Die Abtrennströme 5, 6, 7 werden (zumindest teilweise) zusammengeführt (siehe Schritt 305) zu einem aufzubereitenden Medium 31 bzw. einer Mischung an Spülwässern (Gesamtabtrennstrom). Auch weitere Spülwässer 32 des Herstellungsverfahrens können hier einfließen. Das aufzubereitende Medium 31 wird, wie oben beschrieben, mittels des dritten Aufbereitungsprozesses 300 aufbereitet, um die Konzentration für das Rückgewinnen 400 deutlich zu erhöhen.

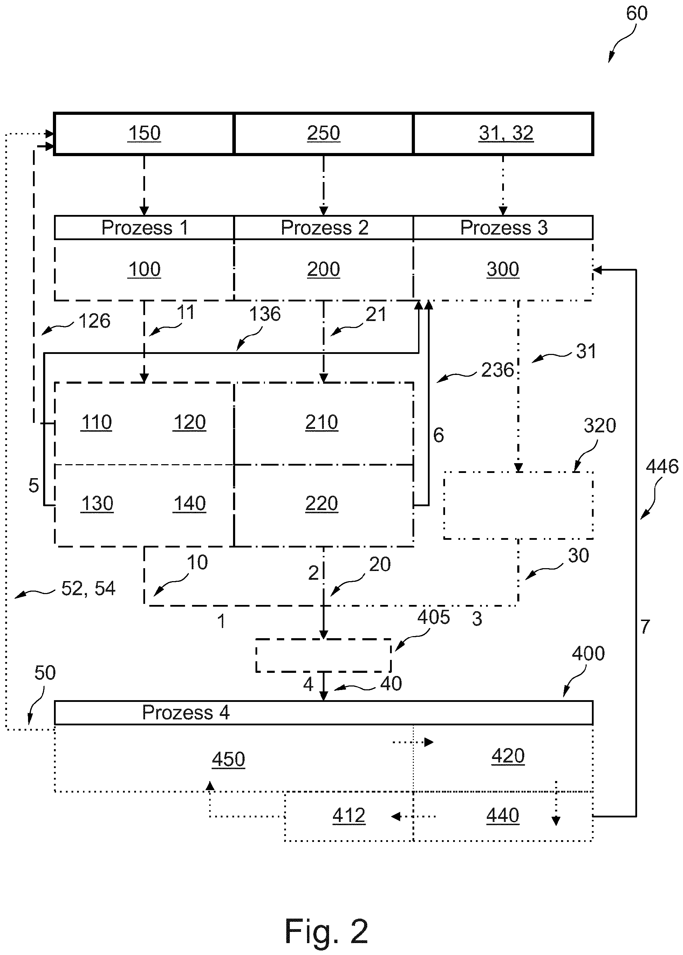

**Figur 2** zeigt eine Übersicht der Teilströme beim Herstellen von Leiterplatten und/oder Substraten, z.B. in einer Industrieanlage 60, gemäß einem weiteren Ausführungsbeispiel der Erfindung. Der Wertstoffkreislauf entspricht dem für Figur 1 oben beschriebenen in anderer Darstellungsweise. Es ist ferner gezeigt, dass das Rückgewinnen 400 ein (kontinuierliches) Einstellen der Zusammensetzung des Elektrolyten (bzw. des Metallsalz-haltigen Mediums) 40 aufweist. So wird der Elektrolyt aus der Reaktionszelle 450 (kontinuierlich) behandelt mittels eines organischen Filters 412, eines Separierens von Fremdmetall 420, und eines Separierens von Säure 440 (bei zu hoher Säurekonzentration).

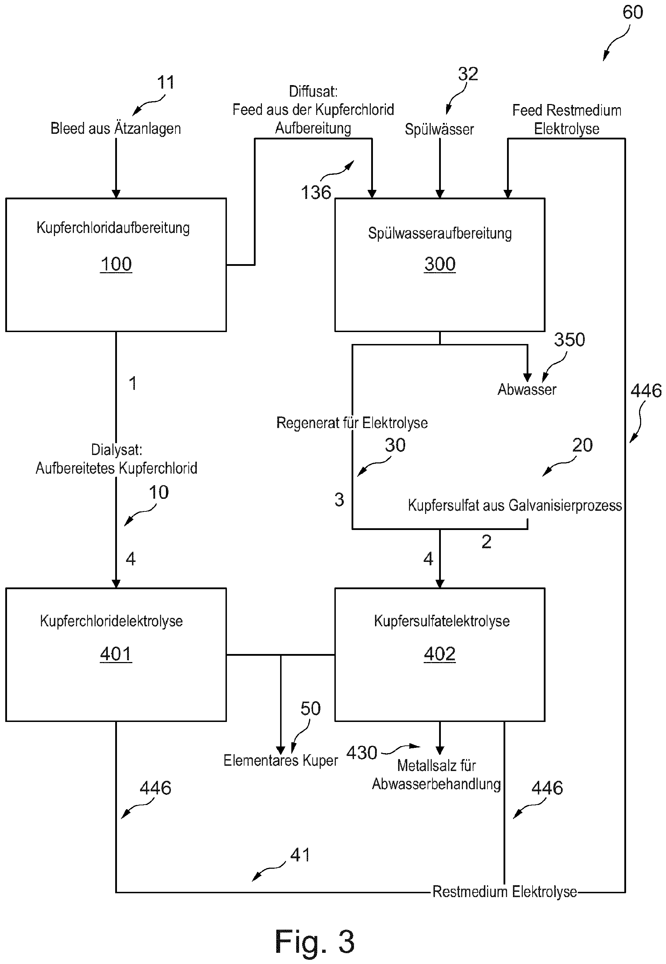

**Figur 3** zeigt ein exemplarisches Ausführungsbeispiel des für die Figuren 1 und 2 bereits beschriebenen Herstellens von gedruckten Leiterplatten und/oder Substraten. In diesem spezifischen Ausführungsbeispiel weist das aufzubereitende Metallsalz Kupferchlorid auf und das Metallsalz weist Kupfersulfat auf. Der Unterschied zu dem für die Figuren 1 und 2 beschriebenen Prozess besteht darin, dass der erste Teilstrom 1 einem ersten Rückgewinnungsprozess 401 (der Begriff "Kupferchloridelektrolyse" bezieht sich hierbei auf das Ausgangsmaterial, es findet eine Kupfersulfatelektrolyse statt) zugeführt wird und ein Gesamtstrom 4, welcher aus dem zweiten Teilstrom 2 und dem dritten Teilstrom 3 besteht, einem zweiten Rückgewinnungsprozess 402 zugeführt wird.

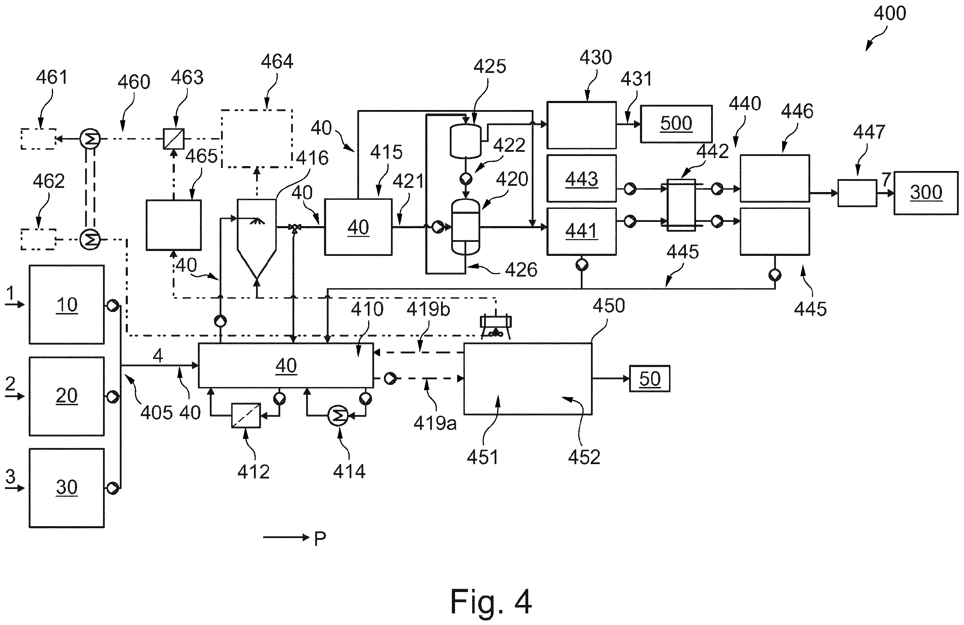

**Figuren 4** zeigt das Verfahren 400 zum Rückgewinnen von elementarem Metall 50 aus einem Metallsalz-haltigen Medium 40 aus der Leiterplatten- und/oder Substrat-Herstellung gemäß einem Ausführungsbeispiel der Erfindung. Das Verfahren 400 umfasst ein Bereitstellen 405 des Metallsalz-haltigen Mediums 40, welches ein Metallsalz (z.B. Kupfersulfat) und ein Fremdmetall (z.B. Eisen) aufweist, wobei das Fremdmetall chemisch unedler ist als das (abzuscheidende) Metall.

Das Standardpotential (Redoxpotential, bzw. nach DIN 38404-6 "Redox-Spannung") des Fremdmetalls muss hierfür also niedriger sein als das Redoxpotential des abzuscheidenden Metalls.

Metalle mit hohem Redoxpotential (abzuscheidende Metalle) sind beispielsweise: Kupfer Cu²⁺, E⁰ = +0,35V; Kupfer Cu⁺, E⁰ = +0,52V, Palladium Pd²⁺, E⁰ = +0,85V; Gold Au³⁺, E⁰ = +1,4V; Gold Au³⁺, E⁰ = +1,5V; Gold Au⁺, E⁰ = +1,69V; Iridium Ir³⁺, E⁰ = +1,156V; Silber Ag⁺, E⁰ = +0,8V.

Metalle mit hohen Redoxpotential (Fremdmetalle) sind beispielsweise: Eisen Fe³⁺, E⁰ = -0,04V; Eisen Fe²⁺, E⁰ = -0,41V; Blei Pb²⁺, E⁰ = -0,13V; Zinn Sn²⁺, E⁰ = -0,14V; Molybdän Mo³⁺, E⁰ = -0,20V; Nickel Ni²⁺, E⁰ = -0,23V; Kobalt Co²⁺, E⁰ = -0,28V; Indium In³⁺, E⁰ = -0,34V; Cadmium Cd²⁺, E⁰ = -0,40V; Zink Zn²⁺, E⁰ = -0,76V; Chrom Cr³⁺, E⁰ = -0,76V; Natrium Na⁺, E⁰ = -2,71V. Insbesondere bei Eisen (Fe³⁺ -> Fe²⁺, E⁰ = + 0,77) findet eine Reaktion statt, bei welcher durch das Fe²⁺ abgeschiedenes Kupfer wieder von der Elektrode weggeätzt wird.

Das elementare Metall 50 (z.B. Kupfer) des Metallsalz-haltigen Mediums 40 soll in einer Reaktionszelle 450 in reiner Form rückgewonnen werden, um dem Prozess zum Herstellen von Leiterplatten und/oder Substraten erneut zugeführt zu werden. Insbesondere wird das elementare Metall 50 in den Galvanisierungsprozess 250 rückgeführt (bei 54). Optional kann auch elementares Metall 50 in den Ätzprozess 150 rückgeführt werden (bei 52). Unedles Fremdmetall stört die Rückgewinnung des elementaren Metalls 50, welche bevorzugt im Rahmen einer Elektrolyse 451 durchgeführt wird. Anstelle eines aufwendigen weiteren Aufbereitungsprozesses (das Metallsalz-haltige Medium 40 stammt in bestimmten Fällen bereits aus drei verschiedenen Aufbereitungsprozessen 100, 200, 300), findet nun in der Reaktionszelle 450 ein Oxidieren 452 des Fremdmetalls statt.

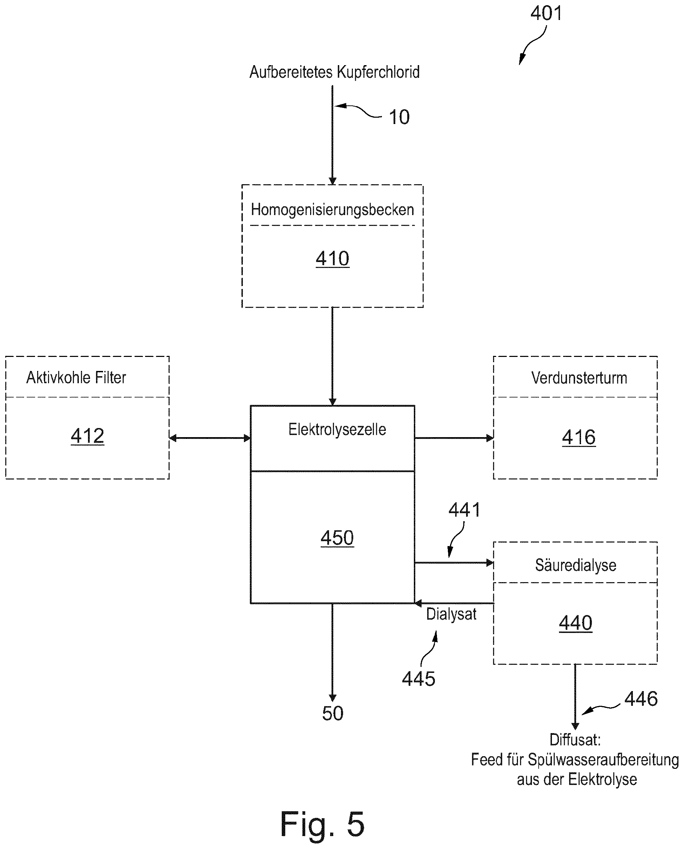

Das Metallsalz-haltige Medium 40 wird bereitgestellt aus i) dem Metallsalz-haltigen Medium 10 aus dem Ätzprozess 150 mittels des ersten Teilstroms 1, ii) dem Metallsalz-haltigen Medium 20 aus dem Galvanisierungsprozess 250 mittels des zweiten Teilstroms 2, und iii) dem Metallsalz-haltigen Medium 30 aus dem Verfahren 300 zum Aufbereiten von Spülwasser. Diese Teilströme 1, 2, 3 werden gemischt (siehe Schritt 405) zu einem Gesamtteilstrom 4, welcher dem Rückgewinnen 400 zugeführt wird. Gemäß einem Ausführungsbeispiel (siehe Figur 5 unten) kann der erste Teilstrom 1 auch alleine als Gesamtteilstrom 4 verwendet werden. Dies insbesondere dann, wenn das Metallsalz-haltige Medium 10 des ersten Teilstroms 1 nicht vernachlässigbare Rückstände an aufzubereitendem Metallsalz (z.B. Kupferchlorid) und/oder Säure aufweist. Das Metallsalz-haltige Medium 20 aus dem Galvanisierungsprozess 250 und das Metallsalz-haltige Medium 30 aus dem Verfahren 300 zum Aufbereiten von Spülwasser können dann beispielsweise zu einem weiteren Gesamtstrom 4 vermischt werden.

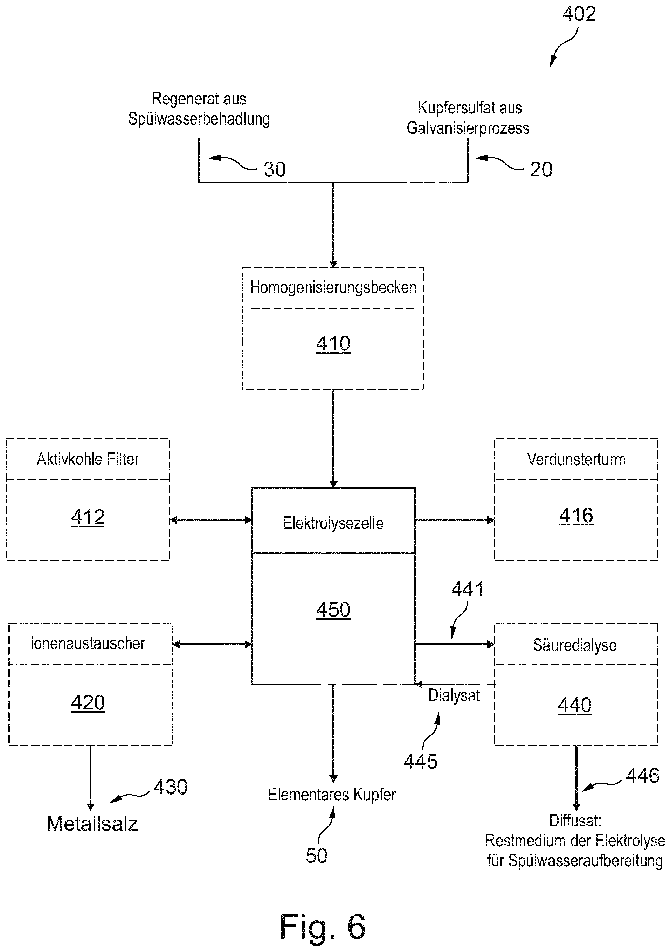

Der Gesamtstrom 4 mit dem Metallsalz-haltigen Medium 40 wird in ein Versorgungsbecken bzw. Harmonisierungsbecken 410 geleitet, welches mit der Reaktionszelle 450 in beidseitiger Fluidkommunikation 419a, b verbunden ist. In dem gezeigten Ausführungsbeispiel wird das Versorgungsbecken 410 verwendet, um die Zusammensetzung des Metallsalz-haltigen Mediums 40 (welches den Elektrolyten 40 für die Elektrolyse 451 in der Reaktionszelle 450 darstellt) zu regeln. Bevorzugt wird das Verfahren zum Rückgewinnen 400 kontinuierlich betrieben, so dass das Versorgungsbecken 410 in vorteilhafter Weise eine gewünschte Zusammensetzung des Elektrolyten 40 regelt. Alternativ oder zusätzlich kann das Einstellen der Zusammensetzung des Elektrolyten 40 (bzw. ein kontinuierlich durchgeführtes Regeln) auch direkt von der Reaktionszelle 450 aus erfolgen (siehe hierzu z.B. die Figuren 5 und 6 unten). Die Reaktionszelle 450 weist bevorzugt eine Mehrzahl (z.B. zwanzig) Elektrolyse Module 451 (E-Module) auf, in welchen elementares Metall 50 (z.B. Kupfer) an einer Kathode abgeschieden wird. Bei dieser Reaktion kommt es zur Oxidation 452 von Fremdmetall (des Elektrolyten 40), welches chemisch unedler als das abzuscheidende Metall ist (siehe oben). Ferner weist die Reaktionszelle 450 eine Mehrzahl von Löse-Modulen 455 (L-Module) auf, in welchen das elementare Metall 50 von der Kathode wieder abgetrennt wird, um das elementare Metall 50 in hochreiner Form zu erhalten, welche für ein Wiederverwenden 52, 54 in der Leiterplatten- und/oder Substrat-Herstellung geeignet ist. Abtrennen kann z.B. mittels Säure erfolgen, um eine hochreine Metallsalz-Lösung bereitzustellen. Auch ein mechanisches Abtrennen ist möglich, um das Metall als hochreine Partikel zu erhalten, welche z.B. in Platten umgeformt werden können. Die Reaktionszelle 450 wird mit Vorteil kontinuierlich betrieben. Beispielsweise kann ein kontinuierlicher Transport zwischen E-Modulen 451 und L-Modulen 455 stattfinden. Dies kann z.B. mittels eines flexiblen Transportsystems (nicht gezeigt) realisiert werden (z.B. an der Decke entlang fahrende Vehikel oder Greifer), welche u.a. beladene Kathoden aus den E-Modulen 451 in leere L-Module 455 transportieren und danach die abgereicherten Kathoden nach dem Abtrennen des Metalls 50 wieder in ein leeres E-Modul 451 positionieren.

Das Rückgewinnen 400 kann von einem System 460 unterstützt werden, welches die Luftzirkulation regelt. Hierbei können die Zuluft 462 und die Abluft 461 geregelt werden und über Wärmetauscher die Temperatur. Gesättigte Abluft 464 (z.B. aus einem Verdunster 416) kann einem Filter 463 zugeführt werden. Der Verdunster 416 (z.B. ein Verdunsterturm) kann verwendet werden zum Aufkonzentrieren des Metallsalzes in dem Metallsalz-haltigen Medium 40. Natürliche Verdunstung (die Elektrolyse wird z.B. bei etwa 50°C oder 60°C (insbesondere in dem Bereich 40°C bis 70°C) betrieben) ist in Block 465 dargestellt. Die Temperatur des Elektrolyten 40 wird in dem Bereich von etwa 40°C bis 60°C durch einen Temperaturregler 414, z.B. eine Heizung, eingestellt.

Das Einstellen (insbesondere kontinuierliche Regeln) der Zusammensetzung des Metallsalz-haltigen Mediums 40 (von dem Versorgungsbecken 410 und/oder von der Reaktionszelle 450 aus) umfasst im Wesentlichen drei Schritte: i) Filtern von organischen Bestandteilen mittels eines Filters 412, bevorzugt eines Aktivkohlefilters, aus dem Metallsalz-haltigen Medium 40, ii) Separieren des oxidierten Fremdmetalls aus dem Metallsalz-haltigen Medium 40 mittels eines Ionentauschers 420, und iii) Separieren 440 von Säure (insbesondere Schwefelsäure) aus dem Metallsalz-haltigen Medium 40.

Der Ionentauscher 420 weist ein selektives Ionenaustauschharz (siehe weitere Spezifizierungen eines Ionentauscher(harze)s oben) auf (z.B. 1000 L Harzvolumen bei einem Harzgewicht von 700 kg). Das Metallsalz-haltige Medium 40 wird (nach einem optionalen Aufkonzentrieren mittels des Verdunsters 416) über ein Pumpvorlage-Modul 415 dem Ionentauscher 420 derart zugeführt, dass dieser mit dem Metallsalz-haltigen Medium 40, in welchem das Fremdmetall oxidiert vorliegt, beladen (siehe Schritt 421) wird. Das Fremdmetall adsorbiert hierbei an dem Harz des Ionentauschers 420. Das dadurch erhaltene Metallsalz-haltige Medium 40 ist im Wesentlichen frei von dem oxidierten Fremdmetall und kann zurück in die Reaktionszelle 450 oder das Versorgungsbecken 410 geleitet werden. In dem gezeigten Beispiel wird das erhaltene Metallsalz-haltige Medium 40 als Dialyse Zulauf 441 für das Separieren 440 von Säure aus dem Metallsalz-haltigen Medium 40 verwendet (siehe Beschreibung unten).

Der beladene Ionentauscher 420 wird regeneriert (bei 422) mittels Strömens einer sauren Lösung 425 durch den Ionentauscher 420. Dies bevorzugt im Gegenstrom, um die Menge an benötigter Säure für die Regeneration geringstmöglich zu halten. Das Einsparungspotential kann hierbei z.B. ca. 30% Säure betragen.

Dadurch wird das Fremdmetall in der sauren Lösung 425 gelöst und eine Fremdmetall-haltige saure Lösung 426, 430 wird als Regenerat 426 erhalten. Um ein kontinuierliches Rückgewinnen zu ermöglichen, wird des Regenerats 426 (zumindest teilweise) als weiteres Regeneriermedium 425, 426 für mehrere weitere Regenerierschritte 422 in dem Ionentauscher 420 verwendet. Bevorzugt steigt mit jedem Regenerierschritt 422 die Konzentration an Fremdmetall in dem Regenerat 426 an, so dass nach einigen Regenerierschritten 422 ein konzentriertes Regenerat 430 vorliegt. Die Fremdmetall-haltige saure Lösung des Regenerats 426 bzw. das konzentrierte Regenerat 430 werden bereitgestellt (siehe Schritt 431) an einen weiteren Prozess 500 bei der Leiterplatten- und/oder Substrat-Herstellung. Gemäß einem exemplarischen Ausführungsbeispiel handelt es sich bei dem Fremdmetall um Eisen und bei der Säure 425 um Salzsäure, so dass im Regenerat 430 Eisenchlorid gebildet wird. Dieses kann z.B. als Fällungsmittel verwendet werden, um Fotolack (siehe oben) aus Abwässern bzw. Prozesswässern zu fällen. Gemäß einem exemplarischen Ausführungsbeispiel kann das Separieren 420 des Fremdmetalls als eigenständiger Prozess betrieben werden, um (insbesondere kontinuierlich) Eisenchlorid zu produzieren.

Während der Elektrolyse 450 entsteht Schwefelsäure, welche vom Elektrolyt 40 abgetrennt werden muss, um die gewünschte Abscheiderate erhalten zu können. Mit steigender Schwefelsäurekonzentration nimmt die Menge an abzuscheidendem Kupfer 50 ab. Das Separieren 440 der Säure weist das Durchführen einer Membrandialyse auf. Das Metallsalz-haltige Medium (bzw. der Elektrolyt) 40 werden der Membrandialyse 440 als Dialysat 441 zugeführt. Ein Zulauf 443 des Diffusats der Membrandialyse 440 beinhaltet entsalztes Wasser. Die Membran 442 kann aufgebaut sein wie oben für die anderen Membrandialysen beschrieben. Durch das Separieren 440 wird das Metallsalz-haltige Medium 40 mit einer deutlich geringeren Säure-Konzentration als Dialysat 445 erhalten, während das Diffusat 446 eine hohe Säure-Konzentration (insbesondere Schwefelsäure) aufweist. Das Säure-haltige Diffusat 446 wird im Zuge des dritten Abtrennstroms 7 an das Verfahren 300 zum Aufbereiten von Spülwasser aus der Leiterplatten- und/oder Substrat-Herstellung bereitgestellt (siehe Schritt 447) bzw. rückgeführt.

Eine Alternative bzw. Ergänzung (eine kontinuierliche Membrandialyse 440 vom Elektrolyten 40 erfordert ein großes Volumen an Wasser, was wiederum Maßnahmen wie einen Verdunsterturm erfordert, um die Säure in einer geeigneten Konzentration wieder zurückgewinnen zu können) hierzu ist das Betreiben der Elektrolyse 450 nur so lange, bis der Elektrolyt 40 eine definierte Säure- und Kupfer Konzentration (z.B. Cu²⁺ etwa 5 g/L) erreicht hat. Anschließend kann dieser verbrauchte Elektrolyt 41 für die Regeneration des Ionenaustauschers 320 zur Aufbereitung 300 der Spülwässer herangezogen werden. Dadurch verbleibt das Kupfer im Wertstoffkreislauf und die Säure muss nicht (kontinuierlich) über eine Dialyse 440 in einem zusätzlichen Prozessschritt abgetrennt werden.

In einem weiteren Ausführungsbeispiel wird der Ionenaustauscher 320 der Spülwässer mit verbrauchtem Elektrolyt 41, der nur noch eine geringe Konzentration an Kupfer aufweist, regeneriert. Während der Elektrolyse 450 entsteht Schwefelsäure, welche vom Elektrolyt 40 abgetrennt werden muss, um die gewünschte Abscheiderate erhalten zu können. Mit steigender Schwefelsäurekonzentration nimmt die Menge an abzuscheidendem Kupfer 50 ab. Würde Säure beispielsweise kontinuierlich mittels Membrandialyse 440 vom Elektrolyten 40 getrennt werden, würde hierfür wieder eine große Menge an Wasser eingesetzt werden. Dies erfordert (Energie-intensive) Maßnahmen wie einen Verdunsterturm, um die Säure in einer geeigneten Konzentration wieder zurückgewinnen zu können. Eine Alternative hierzu ist das Betreiben der Elektrolyse 450 nur so lange, bis der Elektrolyt 40 eine definierte Säure- und Kupfer Konzentration (z.B. Cu²⁺ etwa 5 g/L) erreicht hat. Anschließend kann dieser verbrauchte Elektrolyt 41 für die Regeneration des Ionenaustauschers 320 zur Aufbereitung der Spülwässer 300 herangezogen werden. Dadurch verbleibt das Kupfer im Wertstoffkreislauf und die Säure muss nicht über eine Dialyse 440 in einem zusätzlichen Prozessschritt abgetrennt werden.

In einem exemplarischen Ausführungsbeispiel kann während der Elektrolyse 450 ein großes Volumen Schwefelsäure (z.B. 1000 L pro Tag) anfallen. Dadurch kann (im Wesentlichen) die gesamte Menge an produzierter Schwefelsäure als Regeneriersäure (bzw. Regeneriermedium) für das Aufbereiten 300 von Spülwässern herangezogen werden. Dies kann den Vorteil bereitstellen, dass (im Wesentlichen) keine Schwefelsäure in den Wertstoffkreislauf zugeführt (bzw. zugekauft) werden muss. In einem spezifischen Ausführungsbeispiel kann dennoch mit frischer Schwefelsäure "nachgeschärft" werden.

**Figur 5** zeigt den Prozess zum Rückgewinnen 400 des elementaren Metalls 50 aus dem Metallsalz-haltigen Medium 40, welcher für Figur 4 oben im Detail beschrieben wurde, nochmals aus Gründen der Übersicht als Flussdiagram. In diesem exemplarischen Ausführungsbeispiel wird als Metallsalz-haltiges Medium 40 das Metallsalz-haltige Medium 10 aus dem Aufbereiten der Rückstände 11 des Ätzprozesses 150 verwendet (zunächst in ein Harmonisierungsbecken 410 eingeleitet). Das Einstellen bzw. Regeln der Zusammensetzung des Metallsalz-haltigen Mediums 40 wird von der Reaktionszelle 450 aus durchgeführt. Diese steht in Fluidkommunikation mit dem Aktivkohlefilter 412, dem Verdunster (-turm) 416, und der Membrandialyse 440. Der Ionentauscher 420 ist in diesem exemplarischen Ausführungsbeispiel nicht notwendig, da das Metallsalz-haltige Medium 10 (aus dem Aufbereiten der Rückstände 11 des Ätzprozesses 150) nur geringe Konzentration an Fremdmetallen (z.B. Eisen) aufweist.

In einem exemplarischen Ausführungsbeispiel ist das aufzubereitende Metallsalz 11 Kupferchlorid. Ein Großteil des Chlorids kann mittels der Membrandialysen 110, 120, 130 und dem Umsalzen 140 entfernt werden, allerdings kann noch ein Restgehalt an Chlorid im Elektrolyten 40 verbleiben. Eine zu hohe Chlorid-Konzentration im Elektrolyten 40 kann zu einer Chlorid Verunreinigung des abgeschiedenen Kupfers 50 führen. Mit steigender Chlorid Konzentration steigt auch die potentielle Bildung von Chlorgas. Daher kann die Elektrolyse-Zelle 450 zusätzlich mit einer Absaugung ausgestattet sein, welche einen Chlorgas-Austritt verhindern soll. Chlorgas ist ein schweres Gas, das sich an der Elektrolysebad-Oberfläche absetzt. Daher wird eine Luftzufuhr und Luft-Absaugvorrichtung (prinzipiell von links nach rechts in der Figur) entlang der Badoberfläche installiert. Die abgesaugte Luft wird dann über einen Filter (Luftwäscher) wieder aus dem Prozess geleitet.

Damit die abgeschiedene Kupfermenge die entsprechende Reinheit für eine mögliche Rückführung in den Prozess erzielt, darf die Chlorid Konzentration nicht zu hoch werden. Der Grenzwert liegt hierbei in einem Ausführungsbeispiel bei ca. 3 g/L Cl⁻ im Elektrolyten. Ein sortenreines Verwenden des Metallsalz-haltigen Mediums 10 aus Teilstrom 1 kann daher den Vorteil haben, dass bei zu hoher Chlorid-Konzentration die Kupferabscheidung separat von den anderen Trennströmen 2, 3 durchgeführt wird.

**Figur 6** zeigt den Prozess zum Rückgewinnen 400 des elementaren Metalls 50 aus dem Metallsalz-haltigen Medium 40, welcher für Figur 4 oben im Detail beschrieben wurde, nochmals aus Gründen der Übersicht als Flussdiagram. In diesem exemplarischen Ausführungsbeispiel wird als Metallsalz-haltiges Medium 40 eine Mischung aus dem Metallsalz-haltigen Medium 20 aus dem Aufbereiten der Rückstände 21 des Galvanisierungsprozesses 250 und dem Metallsalz-haltigen Medium 30 aus dem Aufbereiten der Spülwässer 31 verwendet (zunächst in ein Harmonisierungsbecken 410 eingeleitet). Das Einstellen bzw. Regeln der Zusammensetzung des Metallsalz-haltigen Mediums 40 wird von der Reaktionszelle 450 aus durchgeführt. Diese steht in Fluidkommunikation mit dem Aktivkohlefilter 412, dem Verdunster (-turm) 416, der Membrandialyse 440, und dem Ionentauscher 420. Insbesondere das Metallsalz-haltige Medium 20 aus dem Aufbereiten der Rückstände 21 des Galvanisierungsprozesses 250 kann eine hohe Konzentration an Fremdmetallen (z.B. Eisen) aufweisen.

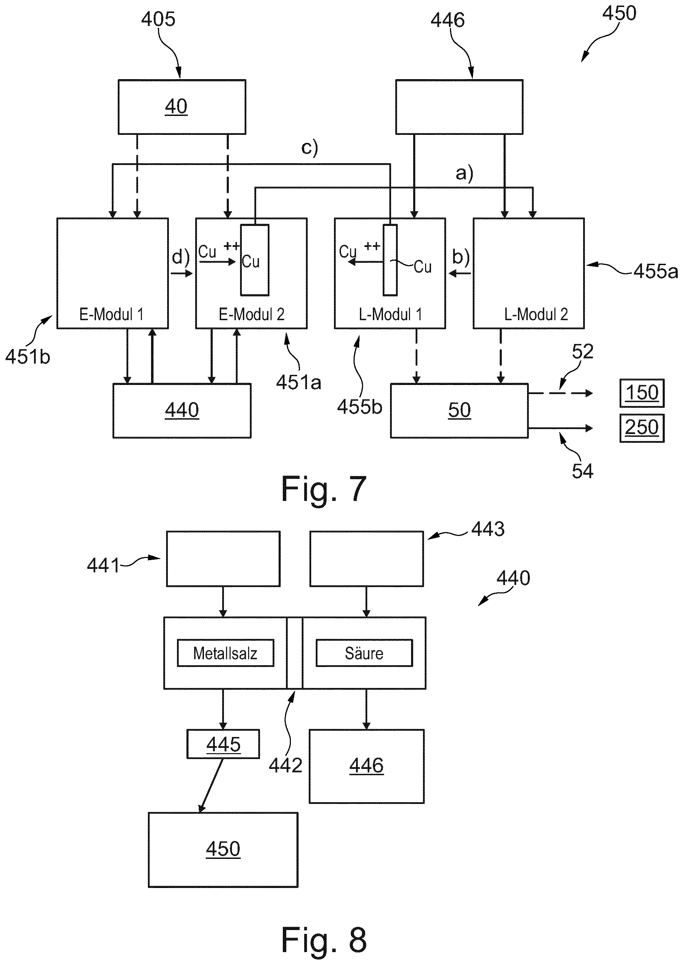

**Figur 7** zeigt detailliert ein exemplarisches Ausführungsbeispiel des Rückgewinnens 400 des elementaren Metalls 50 aus dem Metallsalz-haltigen Medium 40 mittels einer Elektrolyse 451 in der Reaktionszelle 450. In diesem exemplarischen Ausführungsbeispiel weist das Metallsalz Kupfersulfat auf und das elementare Metall 50 weist Kupfer auf. Um eine geeignete Konzentration an Kupfersulfat im Elektrolyten 40 zu gewähren, wird der Elektrolyse ein Verdunster (nicht gezeigt) vorangestellt. In den E-Modulen 451a,b kann mittels Platten- oder Trommel-Elektrolyse das Kupfer bei einer Temperatur von ca. 50°C-60°C abgeschieden werden. Die Kupferlösung (Elektrolyt) 40 wird innerhalb des E-Moduls umgewälzt und ggf. gezielt an die Kathode geströmt (siehe E-Modul 451a). An dieser findet die Kupferabscheidung dadurch vermehrt statt. Das Verfahren arbeitet bevorzugt kontinuierlich. Die Verarmung des Kupfers im Elektrolyten 40 durch dessen Abscheidung an der Kathode wird mit frischer Kupfersulfat-Lösung stetig ausgeglichen.

In einem speziellen Ausführungsbeispiel wird die Elektrolyse bis zu einer definierten Konzentration an Sulfat- und Kupfer-Ionen betrieben (z.B. Cu²⁺ etwa 5 g/L in etwa 100-300 g/L Schwefelsäure). Hierbei kann indirekt die Abscheiderate von Kupfer über die Säurekonzentration gesteuert werden: je höher die Säurekonzentration, desto wahrscheinlicher fällt auch Kupfer in Form von Kupfersulfat aus. Anschließend wird der (saure) Elektrolyt abgepumpt und z.B. als Regenerierhilfe (Regeneriermedium) dem Ionenaustauschharz zur Aufbereitung 300 der Spülwässer zugeführt.

In diesem Ausführungsbeispiel (analog für andere Metalle bzw. Metallsalze) wird kein Verdunsterturm benötigt, da nicht kontinuierlich Wasserdampf entfernt werden muss. Dies kann einen deutlichen Vorteil darstellen, denn ein Verdunsterturm verbraucht im Betrieb sehr viel Energie, z.B. 400 KW/h und ca. 10000 KW pro Tag. Auf diese Weise kann aufzuwendende Energie eingespart werden und dem Wertstoffkreislauf muss weniger Energie zugeführt werden.

Auch wird in diesem Ausführungsbeispiel keine Säuredialyse 440 benötigt, um die anfallende Säure abzutrennen, denn die angereicherte Säure kann (direkt) als Regenerierhilfe (Regeneriermedium) 325, 326 verwendet werden. Dadurch wird die benötigte Menge an Wasser für den Gesamtprozess ebenfalls reduziert.

Die einzelnen Elektrolysezellen 450 werden in einem spezifischen Beispiel bevorzugt Batch-weise (nicht kontinuierlich) betrieben: während des Abpumpens des Elektrolyten wird die Elektrolyse angehalten. Durch eine Prozessanordnung von mehreren parallellaufenden Elektrolyse-Zellen 450 ist jedoch wieder ein kontinuierlicher Kupferabscheidungs-Prozess ermöglicht.

Das Volumen innerhalb des E-Moduls 451a wird automatisch überwacht. Jedes Modul besitzt eine sog. Badabsaugung um Wasserdampf kontrolliert abzuführen. Dadurch wird die Zugabe der Kupfersulfat-Lösung 40 im Abgleich mit der Wasserverdunstung gesteuert. Die Wasserverdunstungsrate (Liter pro Stunde) wird mit der notwendigen Zugabe von Kupfersulfat-Lösung (Liter pro Stunde) abgestimmt. Hat sich auf der Kathode eines E-Moduls 451a ausreichend viel hochreines Kupfer abgeschieden, wird das Substrat (Kathode) samt abgeschiedenem Kupfer automatisch in ein Kupfer-Lösemodul (siehe L-Modul 455a) transportiert (Schritt a). Dies geschieht mit einem programmgesteuerten Transportsystem, welches mit einer vertikalem Hub- und Senkvorrichtung ausgestattet ist und oberhalb der gesamten Modulreihe (E-Module 451a,b und L-Module 455a,b) jede Modul-Position erreichen kann. Ist eine bestimmte Kupferkonzentration im Elektrolyten 40 des L-Moduls (nun 455b) erreicht (Schritt b), wird der von Kupfer abgereicherte Substratträger (vormals Kathode) automatisch vom Transportsystem von dem L-Modul (siehe 455b) wieder in ein freies E-Modul 451b gesetzt (Schritt c). Die Gewichtsabnahme (Lösen des Kupfers) am Substratträger kann gemessen werden, ebenso die Gewichtszunahme (Kupferabscheidung). Mit dieser Verfahrensweise entsteht ein Pendelbetrieb zwischen E-Modul 451 und L-Modul 455. Die Kupferfracht wird gezielt als Kupfersulfat in die bestehenden Kupfer Redumaten verteilt und so in die Produktion zurückgeführt. Dort kann die Kupferkonzentration zusätzlich angeglichen und an die Leiterplatten Produktion weitergegeben werden. Das Verteilersystem der Redumaten bleibt bestehen. Eine weitere Methodik zur Freisetzung des an der Elektrode abgeschiedenen Kupfers wäre ein Lösen des Kupfers mittels Säure, z.B. Schwefelsäure. Auch in diesem Fall, könnte das Kupfer in flüssiger Form dem Prozess zurückgeführt werden. Das Kupfer sollte zunächst oxidiert werden, denn Schwefelsäure oxidiert, und in weiterer Folge löst, Kupfer nur langsam. Daher kann ein Oxidations(hilfs)mittel zugeführt werden, im einfachsten Fall Sauerstoff. Deutlich beschleunigt kann das Lösen mittels Wasserstoffperoxid stattfinden.

Auch ein Abklopfen und anschließendes Schreddern des abgeschiedenen Kupfers kann verwendet werden, um Kupfer in fester Form dem Prozess zurückzuführen. Während des Betriebs wird vorteilhaft an den E-Modulen 451a,b regelmäßig (kontinuierlich) eine Membrandialyse 440 durchgeführt, um einem Überschuss an Säure entgegenzuwirken.

**Figur 8** zeigt detailliert ein exemplarisches Ausführungsbeispiel der Membrandialyse 440 während dem Rückgewinnen des elementaren Metalls 50 aus dem Metallsalz-haltigen Medium 40. Die Verdunstungsrate während der Elektrolyse kann durch Umwälzung, Elektrolyttemperatur und Absauggeschwindigkeit beeinflusst werden. Um eine Aufkonzentrierung von Sulfat (SO₄²⁻) und Elektrolytschmutz zu verhindern, ist wiederum die Membrandialyse 440 vorgesehen, welches kontinuierlich eine Art "Nierenfunktion" ausführt. Dabei wird Schwefelsäure vom Elektrolyten 441 abgetrennt und somit der pH-Wert des Elektrolyten 40 konstant gehalten. Das (Schwefelsäure) Diffusat 446, welches zum Lösen des Kupfers benötigt wird (siehe oben), wird kontinuierlich mit frischer Säure nachgeschärft und anschließend dem L-Modul 455a,b zugeführt. Das Dialysat 445 wird über einen Aktivkohlefilter geleitet um restliche organische Zusatzstoffe, die sich andernfalls im Elektrolyten ansammeln würden, abzutrennen. Anschließend wird das Dialysat 445 der Reaktionszelle 450 bzw. Elektrolyse 451 zurückgeführt.

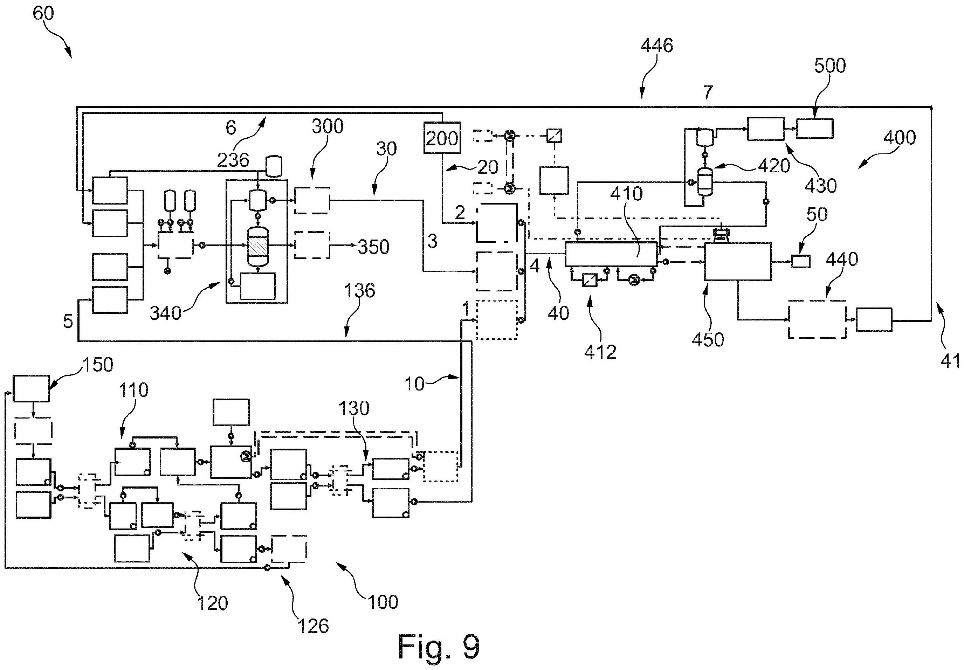

**Figur 9** zeigt eine Übersicht der Aufbereitungsprozesse 100, 200, 300 und des Rückgewinnens 400 bei der Leiterplatten- und/oder Substrat-Herstellung gemäß einem Ausführungsbeispiel der Erfindung. Die Übersicht zeigt die Verzahnung sämtlicher Prozesse ineinander und den sich hieraus ergebenden Wertstoffkreislauf. Die Prozesse wurden für die oben ausgeführten Ausführungsbeispiele jeweils bereits im Detail diskutiert.

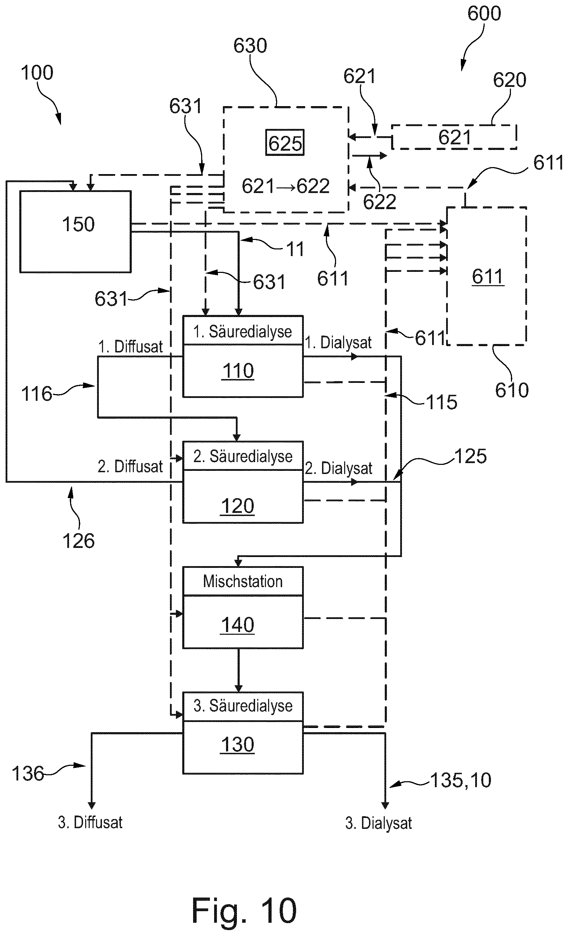

**Figur 10** zeigt eine Prozesskontrollvorrichtung 600 zum Regulieren (bzw. Regeln) von zumindest einem Teil des oben beschriebenen Verfahrens (bzw. der Industrieanlage 60) gemäß einem Ausführungsbeispiel der Erfindung. In dem gezeigten Beispiel ist die Prozesskontrollvorrichtung 600 in den ersten Aufbereitungsprozess 100 zum Bereitstellen des ersten Metallsalz-haltigen Mediums 10 aus einem Ätzprozess 150 aus der Leiterplatten- und/oder Substrat-Herstellung implementiert. Auf dieselbe Weise kann die Prozesskontrollvorrichtung 600 auch in die weiteren (oben beschriebenen) Prozesse (bzw. Verfahren) implementiert werden.

Die Prozesskontrollvorrichtung 600 weist auf: i) eine Datenbank 610 zum Erfassen von zumindest einem Prozessparameter 611 aus dem laufenden (im Betriebszustand befindlichen) Prozess (in dem gezeigten Beispiel der erste Aufbereitungsprozess 100). In dem exemplarischen Ausführungsbeispiel ist gezeigt, dass an allen Prozessschritten Prozessparameter (Werte und/oder Bereiche) 611 erfasst werden (z.B. mittels Sensoren) und der Datenbank 610 zugeführt werden. Die Prozessparameter stellen daher "Ist"-Werte dar (z.B. HCl Konzentration, Kupfer Konzentration, Druckdifferenz, etc). Die Prozesskontrollvorrichtung 600 weist ferner auf: ii) eine Datenmodell-Einheit 620, welche eingerichtet ist zum Speichern von zumindest einem vorbestimmten Prozessparameter 621 (Werte und/oder Bereiche). In dem gezeigten Beispiel werden eine Vielzahl von Prozessparametern gemäß einem oder mehr Datenmodellen in der Datenmodell-Einheit 620 für die verschiedenen Prozessschritte bereitgestellt. Diese vorbestimmten Prozessparameter 621 stellen daher "Soll"-Werte dar. Die Prozesskontrollvorrichtung 600 weist ferner auf: iii) eine Berechnungsvorrichtung 630 (z.B. eine einzelne (separate) Einheit oder eine Mehrzahl von Einheiten), welche eingerichtet ist zum a) Vergleichen des erfassten Prozessparameters 611 (bzw. der Mehrzahl dieser Parameter) mit dem vorbestimmten Prozessparameter 621 (bzw. der Mehrzahl dieser Parameter) (z.B. Vergleich "Ist-Wert" gegen "Soll"-Wert), b) Bestimmen einer Steueroperation 631, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation 631 (z.B. Flussrate anpassen).

Gemäß einem exemplarischen Ausführungsbeispiel der (Software-basierten) Prozesskontrollvorrichtung 600 sammelt die Datenbank 610 Daten aus dem laufenden Prozess (Prozessparameter 611) bzw. greift auf Werte aus einem vorgelagerten Prozessschritt (Prozessparameter 611) zu und archiviert daher (alle) "Ist"-Werte. Ein Datenmodell bzw. mehrere voneinander unabhängige Datenmodelle (welche(s) in der Datenmodell-Einheit 620 z.B. ebenfalls in Form einer Datenbank angelegt sind/ist) beinhalten u.a. "Soll"-Werte (bzw. "Soll"-Bereiche), optional auch deren Zusammenhänge und Variablen (z.B. Datenmodelle 621 als Referenzwerte/Referenzmodelle, die zur Überprüfung der "Ist"-Werte 611 herangezogen werden). Die Berechnungsvorrichtung 630 gleicht die "Ist"-Werte mit den "Soll"-Werten (bzw. setzt einen Rechenschritt basierend auf den Datenmodellen 621 in Kombination mit den "Ist"-Werten 611) ab und setzt anschließend eine Aktion (Steueroperation 631) entsprechend dem Abgleichergebnis (z.B. "Ist"-Wert entspricht "Soll"-Wert, "Ist"-Wert weicht von "Soll"-Wert ab, "Ist"-Wert erfüllt bestimmte Kriterien, etc). Die bestimmte Steueroperation 631 kann (zumindest einen Teil) eines Verfahrensschritts wie oben beschrieben aufweisen.

Gemäß einem exemplarischen Ausführungsbeispiel weist die Berechnungsvorrichtung 630 einen selbstlernenden Algorithmus (AI) 625 (z.B. realisiert mittels neuronaler Netzwerke) auf zum Vergleichen und/oder zum Bestimmen. Der selbstlernende Algorithmus 625 ist eingerichtet, die bestimmte Steueroperation 631 automatisch durchzuführen und/oder einem Benutzer zum Überprüfen bereitzustellen. Ferner ist der selbstlernende Algorithmus 625 eingerichtet basierend auf dem Vergleichen einen neuen vorbestimmten Prozessparameter 622 zu bestimmen und diesen automatisch der Datenmodell-Einheit 620 zuzuführen und/oder dem Benutzer zum Überprüfen bereitzustellen. Bevorzugt ist der selbstlernende Algorithmus 625 eingerichtet, das Ergebnis des Überprüfens durch den Benutzer als Lerngrundlage zu verwenden.
Gemäß einem exemplarischen Ausführungsbeispiel weist die Berechnungseinheit 630 einen selbstlernenden Algorithmus 625 auf, der Aktionen (Steueroperationen 631) setzt, welche entweder direkt im System implementiert werden oder die dem Operator zur Überprüfung zur Verfügung gestellt werden. Zudem kann die Entscheidung des Operators bei der Überprüfung wiederum die Lerngrundlage für die AI-Funktion bilden. Ferner kann die AI basierend auf den erfassten "Ist"-Werten 611 neue "Soll"-Werte/Bereiche 621 kreieren bzw. vorschlagen, die dann entweder automatisch oder Operator-gesteuert in das Datenmodell übernommen werden.

In einem spezifischen Ausführungsbeispiel werden die folgenden Prozessparameter 611 überwacht bzw. gemessen (im Folgenden angegeben ist jeweils eine beispielhafte Messmethode) und in der Datenbank 610 erfasst:
i) Füllstände; mittels Ultraschallmessungen,
ii) Volumenströme; mittels Flowmeter,
iii) H₂O₂ Konzentration; über das Redoxpotential bestimmt,
iv) Säure Konzentration; pH Wert (in-line) oder Titration (Proben ziehen),
v) Organik Konzentration; photometrisch (in-line) oder Cyclovoltammetrie (Proben ziehen),
vi) Chlorid Konzentration; Titration (Proben ziehen),
vii) Eisen/Kupfer Konzentration; photometrisch oder Dichtemessungen (in-line) oder Titration (Proben ziehen),
viii) Temperatur; Temperatursensoren (in-line),
ix) Differenzdruck bei der Membrandialyse zwischen Diffusat und Dialysat; Drucksensoren (in-line).

In diesem spezifischen Ausführungsbeispiel werden nach dem Vergleichen (bzw. Auswerten, Datenanalyse) der bestimmten (gemessenen) Prozessparameter 611 und der vorbestimmten Prozessparameter 621 durch die Berechnungsvorrichtung 630 mittels der Berechnungsvorrichtung 630 z.B. die folgenden Steueroperationen 631 (bzw. Aktionen) bestimmt und durchgeführt (bzw. getriggert):
i) Chlorgas-Bildung (z.B.: über Gassensoren); Steueroperation: Elektrolyse aus,
ii) zu hohe Peroxidbelastung; Steueroperation: kein Beladen des Ionentauschers zur Aufbereitung der Spülwässer,
iii) zu niedriger Füllstand; Steueroperation: Pumpen aus,
iv) zu hohe Eisenkonzentration im Elektrolyten; Steueroperation: Zuschalten des Ionenaustauschharzes,
v) zu hohe Säure-Konzentration im Elektrolyten; Steueroperation: Zuschalten des Membrandialyse oder Abpumpen der Elektrolysezelle,
vi) geringe Kupfer-Konzentration im Elektrolyten; Steueroperation: Elektrolysezelle abpumpen und Fördern des Elektrolyten zum Vorbehandlungsbecken der Spülwässer,
vii) zu hoher Differenzdruck bei Membrandialyse; Steueroperation: Volumenströme (Flowrate) anpassen,
viii) Kupfer-Konzentration im Permeat des Ionentauschers zur Aufbereitung der Spülwässer; Steueroperation: Regenerieren,
ix) Eisen-Konzentration im Permeat des Ionentauschers zur Eliminierung von Eisen aus den Galvanikabwässer; Steueroperation: Regenerieren,
x) zu hohe Chlorid-Konzentration im Dialysat; Steueroperation: Volumenströme (Flowrate) anpassen.

**Bezugszeichen**
- 1, 2, 3: Erster Teilstrom, zweiter Teilstrom, dritter Teilstrom
- 4: Gesamtstrom
- 5, 6, 7: Erster Abtrennstrom, zweiter Abtrennstrom, dritter Abtrennstrom
- 52: Metall Rückführung zu Ätzprozess
- 54: Metall Rückführung zu Galvanisierungsprozess
- 60: Industrieanlage zum Herstellen gedruckter Leiterplatten

- 100: Aufbereitung eines Metallsalz-haltigen Mediums aus einem Ätzprozess aus der Herstellung gedruckter Leiterplatten

- 10: Metallsalz-haltiges Medium
- 11: Aufzubereitendes Medium
- 15: Säure
- 15a: Erster Teil Säure
- 15b: Zweiter Teil Säure
- 15c: Dritter Teil Säure
- 110: Erste Membrandialyse
- 112: Erste Membran
- 113: Erster Zulauf
- 115: Erstes Dialysat
- 116: Erstes Diffusat
- 120: Zweite Membrandialyse
- 122: Zweite Membran
- 123: Zweiter Zulauf
- 125: Zweites Dialysat
- 126: Zweites Diffusat
- 127: Ätzprozess Sammelbecken
- 130: Dritte Membrandialyse
- 131: Zulauf für Dialysat
- 132: Dritte Membran
- 133: Dritter Zulauf
- 135: Drittes Dialysat
- 136: Drittes Diffusat (erster Abtrennstrom)
- 140: Reaktor, Mischen und Durchführen der chemischen Reaktion
- 141: Konzentriertes (Säure-freies) aufzubereitendes Medium
- 143: Weitere Säure
- 150: Ätzprozess
- 151: Ätzprozess Überlaufbecken
- 160: Verdunster

- 200: Aufbereitung eines Metallsalz-haltigen Mediums aus einem Galvanisierungsprozess aus der Herstellung gedruckter Leiterplatten
- 20: Metallsalz-haltiges Medium
- 21: Eisen- und Metallsalz-haltiges Medium
- 205: Speicher-Modul, Bereitstellen
- 210: Oxidier-Modul
- 220: Separier-Modul, Ionentauscher
- 221: Beladen
- 222: Regenerieren, Strömen
- 225: Saure Lösung
- 226: Eisen-haltige saure Lösung, Regenerat
- 230: Aufbereiten, Säuredialyse
- 231: Bereitstellen an Leiterplatten Prozess
- 235: Eisen-haltiges Dialysat
- 236: Säure-haltiges Diffusat (zweiter Abtrennstrom)
- 240: Rückführen Säure
- 250: Galvanisierungsprozess

- 300: Aufbereitung eines Metallsalz-haltigen Mediums aus Spülwasser aus der Herstellung gedruckter Leiterplatten

- 30: Metallsalz-haltiges Medium
- 31: Aufzubereitendes Medium, Gesamtabtrennstrom
- 32: Weiteres Spülwasser
- 305: Bereitstellen
- 310: Vorbehandeln
- 311: Behälter Natronlauge, Einstellen pH-Wert
- 312: Behälter Bisulfit, chemisches Reduzieren
- 313: Organik-Filter, Aktivkohlefilter
- 320: Ionentauscher
- 321: Beladen
- 322: Regenerieren, Strömen
- 325: Regeneriermedium, weitere Säure
- 326: Regeneriermedium, Regenerat
- 327: Separieren von Abwasser
- 328: Speicher-Modul für Regenerat
- 329: Bereitstellen von konzentriertem Medium
- 340: Separier-Modul
- 350: Abfall Medium, Wasser mit Einleitqualität
- 351: Aufreinigung Wasser
- 352: Zufuhr Wasser

- 400: Rückgewinnen eines elementaren Metalls aus einem Metallsalzhaltigen Medium aus der Herstellung gedruckter Leiterplatten

- 40: Metallsalz-haltiges Medium, Elektrolyt
- 41: Verbrauchter Elektrolyt
- 50: Elementares Metall (Kupfer)
- 401: Rückgewinnen erster Teilstrom
- 402: Rückgewinnen zweiter und dritter Teilstrom
- 405: Bereitstellen, Zusammenführen, Aufkonzentrieren
- 410: Versorgungsbecken, Einstellen der Zusammensetzung
- 412: Aktivkohlefilter, Filtern
- 414: Temperaturregelung
- 415: Pumpvorlage für Separieren von Fremdmetall
- 416: Verdunster, Aufkonzentrieren
- 419a,b: Fluidkommunikation
- 420: Ionentauscher, Separieren von Fremdmetall
- 421: Beladen
- 422: Regenerieren, Strömen
- 425: Saure Lösung, Regeneriermedium
- 426: Regenerat, Fremdmetall-haltige saure Lösung, Regeneriermedium
- 430: Konzentrierte Fremdmetall-haltige saure Lösung
- 431: Bereitstellen an Leiterplatten Prozess
- 440: Membrandialyse, Separieren von Säure
- 441: Zulauf Dialyse
- 442: Membran
- 443: Zulauf Diffusat
- 445: Dialysat mit Metallsalz
- 446: Diffusat mit Säure (dritter Abtrennstrom)
- 447: Speicher-Modul Säure
- 450: Reaktionszelle, Elektrolysezelle
- 451: Elektrolyse (E-Modul)
- 452: Oxidation
- 455: Ablöse-Modul (L-Modul)
- 460: Luftzirkulation
- 461: Abluft
- 462: Zuluft
- 463: Luftfilter
- 464: Gesättigte Abluft
- 465: Natürliche Verdunstung

- 500: Weiterer Leiterplatten Prozess, Fotolack-Prozess
- 600: Prozesskontrollvorrichtung
- 610: Datenbank
- 611: Prozessparameter, Ist-Wert
- 620: Datenmodell-Einheit
- 621: Vorbestimmter Prozessparameter, Soll-Wert
- 622: Neuer vorbestimmter Prozessparameter
- 625: Selbstlernender Algorithmus
- 630: Berechnungsvorrichtung
- 631: Bestimmte Steueroperation

- P: Prozessrichtung

## Patentansprüche

1. Ein Verfahren (400) zum Aufbereiten eines Metallsalz-haltigen Mediums (40) aus der Leiterplatten- und/oder Substrat-Herstellung, das Verfahren aufweisend:
Bereitstellen (405) des Metallsalz-haltigen Mediums (40), welches ein Metallsalz und ein Fremdmetall aufweist, wobei das Fremdmetall chemisch unedler ist als das Metall;
Rückgewinnen des elementaren Metalls (50) aus dem Metallsalz-haltigen Medium (40) in einer Reaktionszelle (450), insbesondere mittels Elektrolyse (451); und im Wesentlichen zeitgleich
Oxidieren (452) des Fremdmetalls.

2. Das Verfahren (400) gemäß Anspruch 1, ferner aufweisend zumindest eines der folgenden Merkmale:
wobei das Metall zumindest ein Metall aus der Gruppe aufweist, welche besteht aus: Kupfer, Nickel, Cobalt, Palladium, Rhodium, Zinn, Cadmium, Magnesium, Natrium, Silber, Gold;
wobei das Metallsalz ein Metallsulfat, insbesondere Kupfersulfat, CuSO₄, aufweist;
wobei das Fremdmetall zumindest eines aus der Gruppe aufweist, welche besteht aus: Eisen, Blei, Zinn, Molybdän, Nickel, Kobalt, Indium, Cadmium, Zink, Chrom, Natrium, Palladium,
insbesondere wobei das Oxidieren (452) die Reaktion von Fe²⁺ zu Fe³⁺ aufweist;
wobei das Oxidieren (452) in der Reaktionszelle (450) stattfindet, insbesondere während der Elektrolyse (451).

3. Das Verfahren (400) gemäß Anspruch 1 oder 2, aufweisend:
kontinuierliches Zuführen (419a) von Metallsalz-haltigem Medium (40) zu der Reaktionszelle (450).

4. Das Verfahren (400) gemäß einem beliebigen der vorhergehenden Ansprüche, aufweisend:
Einstellen, insbesondere selektives Einstellen, der Zusammensetzung des Metallsalz-haltigen Mediums (40), insbesondere
wobei das Einstellen ein kontinuierlich durchgeführtes Regeln aufweist, weiter insbesondere
wobei das Einstellen von einem Versorgungsbecken (410), insbesondere einem Harmonisierungsbecken, ausgehend erfolgt, welches der Reaktionszelle (450) in Prozessrichtung (P) vorgeschaltet ist, weiter insbesondere
wobei das Versorgungsbecken (410) und die Reaktionszelle (450) in Fluidkommunikation (419a, 419b), insbesondere kontinuierlich, miteinander stehen.

5. Das Verfahren (400) gemäß einem beliebigen der vorhergehenden Ansprüche, wobei das Verfahren, insbesondere das Einstellen, zumindest eines der folgenden Merkmale aufweist:
Filtern (412) von organische Bestandteilen, insbesondere mittels eines Aktivkohlefilters, aus dem Metallsalz-haltigen Medium (40);
Regeln (414) der Temperatur, insbesondere in dem Bereich 40°C bis 70°C, weiter insbesondere 45°C bis 65°C;
Aufkonzentrieren (416) des Metallsalzes in dem Metallsalz-haltigen Medium (40), insbesondere mittels eines Verdunsters (416);

6. Das Verfahren (400) gemäß einem beliebigen der vorhergehenden Ansprüche, wobei das Verfahren, insbesondere das Einstellen, zumindest eines der folgenden Merkmale aufweist:
Separieren (420) des, insbesondere oxidierten, Fremdmetalls aus dem Metallsalz-haltigen Medium (40);
zumindest teilweises Separieren (420) des, insbesondere oxidierten, Fremdmetalls mittels eines Ionentauschers (420), insbesondere eines Ionentauschers, welcher ein selektives Ionenaustauschharz, weiter insbesondere ein doppel-funktionalisiertes Ionenaustauschharz, aufweist;
Beladen (421) des Ionentauschers (420) mit dem Metallsalz-haltigen Medium (40), in welchem das Fremdmetall oxidiert vorliegt, derart, dass das Fremdmetall an dem Ionentauscher (420) verbleibt, insbesondere adsorbiert; und nachfolgend
Regenerieren (422) des Ionentauschers (420) mittels Strömens einer sauren Lösung (425) durch den Ionentauscher (420) derart, dass das Fremdmetall in der sauren Lösung (425) gelöst wird und eine Fremdmetall-haltige saure Lösung (426, 430) als Regenerat (426) bereitgestellt wird;
wobei das Regenerieren (422) ferner aufweist:
Verwenden des Regenerats (426) zumindest teilweise als weiteres Regeneriermedium (425, 426) für einen oder mehr weitere Regenerierschritte (422) in dem Ionentauscher (420),
insbesondere wobei die Konzentration des Fremdmetalls in dem Regenerat (426) mit jedem Regenerierschritt (422) ansteigt, so dass ein konzentriertes Regenerat (430) vorliegt;
Bereitstellen (431) der Fremdmetall-haltigen sauren Lösung (426, 430) an einen weiteren Prozess (500) bei der Herstellung gedruckter Leiterplatten, insbesondere einen Prozess zum Fällen von Fotolack;
wobei das Fremdmetall Eisen aufweist, wobei die saure Lösung (425) Salzsäure, HCl, aufweist, und wobei die Fremdmetall-haltige saure Lösung (426, 430) Eisenchlorid, FeCl₃, aufweist.

7. Das Verfahren (400) gemäß einem beliebigen der vorhergehenden Ansprüche, wobei das Verfahren, insbesondere das Einstellen, ferner aufweist:
Separieren (440) von Säure, insbesondere Schwefelsäure, aus dem Metallsalz-haltigen Medium (40), insbesondere
wobei das Separieren (440) der Säure aufweist:
Durchführen einer Membrandialyse (440), um ein Dialysat (445), welches das Metallsalz aufweist, und ein Diffusat (446), welches die Säure aufweist, zu erhalten.

8. Das Verfahren (400) gemäß Anspruch 7, ferner aufweisend zumindest eines der folgenden Merkmale:
wobei ein Zulauf (443) des Diffusats der Membrandialyse (440) ein Lösungsmittel, insbesondere entsalztes Wasser, aufweist;
wobei die Membrandialyse (440) einen Durchsatz in dem Bereich 0,5 bis 5 L/hm², insbesondere 1 bis 2 L/hm², aufweist;
wobei zumindest eine Membran (442) der Membrandialyse (440) eine Wickelmembran oder eine Plattenmembran aufweist;
Bereitstellen des Säure-haltigen Diffusats (446) als dritter Abtrennstrom (7) an ein Verfahren (300) zum Aufbereiten von Spülwasser aus der Leiterplatten- und/oder Substrat-Herstellung.

9. Das Verfahren (400) gemäß einem beliebigen der vorhergehenden Ansprüche, wobei das Verfahren aufweist:
Bereitstellen des Metallsalz-haltigen Mediums (40) mittels zumindest einem aus der Gruppe zur Leiterplatten- und/oder Substrat-Herstellung, welche besteht aus:
einem Metallsalz-haltigen Medium (10) aus einem Ätzprozess (150) über einen ersten Teilstrom (1);
einem Metallsalz-haltigen Medium (20) aus einem Galvanisierungsprozess (250), insbesondere wobei das Fremdmetall im Wesentlichen aus dem Galvanisierungsprozess (250) stammt, über einen zweiten Teilstrom (2);
einem Metallsalz-haltigen Medium (30) aus dem Verfahren (300) zum Aufbereiten von Spülwasser über einen dritten Teilstrom (3).

10. Eine Vorrichtung (400) zum Aufbereiten eines Metallsalz-haltigen Mediums (40) aus der Leiterplatten- und/oder Substrat-Herstellung, wobei das Metallsalz-haltige Medium (40) ein Metallsalz und ein Fremdmetall aufweist, und wobei das Fremdmetall chemisch unedler ist als das Metall, die Vorrichtung (400) aufweisend:
eine Reaktionszelle (450), insbesondere eine Elektrolysezelle, welche eingerichtet ist zum
Rückgewinnen des elementaren Metalls (50) aus dem Metallsalz-haltigen Medium (40) und, im Wesentlichen zeitgleich,
Oxidieren (452) des Fremdmetalls, ferner aufweisend zumindest eines der folgenden Bestandteile, welche mit der Reaktionszelle (450), insbesondere direkt, in Fluidkommunikation (419a, 419b) koppelbar sind:
einen Filter (412), insbesondere ein Aktivkohlefilter, zum Filtern von organischen Bestandteilen aus dem Metallsalz-haltigen Medium (40);
einen Ionentauscher (420) zum Separieren von dem, insbesondere oxidierten, Fremdmetall aus dem Metallsalz-haltigen Medium (40);
eine Membrandialyse (440) zum Separieren von Säure, insbesondere Schwefelsäure, aus dem Metallsalz-haltigen Medium (40);
ein Versorgungsbecken (410), wobei das Versorgungsbecken (410) eingerichtet ist zum Einstellen, insbesondere kontinuierlich durchgeführten Regeln, der Zusammensetzung des bereitgestellten Metallsalz-haltigen Mediums (40).

11. Die Vorrichtung (400) gemäß Anspruch 10, ferner aufweisend zumindest eines der folgenden Merkmale:
wobei der Ionentauscher (420) der Membrandialyse (440) in Prozessrichtung (P) vorgeschaltet ist;
wobei zumindest eines von dem Ionentauscher (420), der Membrandialyse (440), und dem Filter (412), direkt mit dem Versorgungsbecken (410) in Fluidkommunikation (419a, 419b) koppelbar ist.

12. Ein Verwenden von Eisenchlorid, welches mittels Säure-Regenerierens eines Ionentauschers (420) aus Elektrolyse-oxidiertem Eisen, welches aus einem Rückgewinnungsprozess der Herstellung von Leiterplatten und/oder Substraten stammt, gewonnen wurde, für das Fällen von Fotolack für die Herstellung der Leiterplatten und/oder der Substrate.

13. Eine Prozesskontrollvorrichtung (600) zum Regulieren eines Verfahrens gemäß einem beliebigen der Ansprüche 1 bis 9 und/oder einer Vorrichtung gemäß Anspruch 10 oder 11, wobei die Prozesskontrollvorrichtung (600) aufweist:
eine Datenbank (610) zum Erfassen von zumindest einem Prozessparameter (611) aus dem laufenden Prozess;
eine Datenmodell-Einheit (620), welche eingerichtet ist zum Speichern von zumindest einem vorbestimmten Prozessparameter (621); und
eine Berechnungsvorrichtung (630), welche eingerichtet ist zum Vergleichen des erfassten Prozessparameters (611) mit dem vorbestimmten Prozessparameter (621),
Bestimmen einer Steueroperation (631), welche auf dem Ergebnis des Vergleichens basiert, und
Durchführen der bestimmten Steueroperation (631).

14. Die Prozesskontrollvorrichtung (600) gemäß Anspruch 13, aufweisend zumindest eines der folgenden Merkmale:
wobei die Berechnungsvorrichtung (630) einen selbstlernenden Algorithmus (625), insbesondere mittels neuronaler Netzwerke, zum Vergleichen und/oder zum Bestimmen aufweist;
wobei der selbstlernende Algorithmus (625) eingerichtet ist, die bestimmte Steueroperation (631) automatisch durchzuführen, und/oder wobei der selbstlernende Algorithmus (625) eingerichtet ist, die bestimmte Steueroperation (631) einem Benutzer zum Überprüfen bereitzustellen;
wobei der selbstlernende Algorithmus (625) eingerichtet ist basierend auf dem Vergleichen einen neuen vorbestimmten Prozessparameter (622) zu bestimmen und automatisch der Datenmodell-Einheit (620) zuzuführen, und/oder wobei der selbstlernende Algorithmus (625) eingerichtet ist basierend auf dem Vergleichen einen neuen vorbestimmten Prozessparameter (622) zu bestimmen und dem Benutzer zum Überprüfen bereitzustellen;
wobei der selbstlernende Algorithmus (625) eingerichtet ist, das Ergebnis des Überprüfens durch den Benutzer als Lerngrundlage zu verwenden.

15. Ein Computerprogramm-Produkt zum Steuern eines Verfahrens (400) zum Aufbereiten eines Metallsalz-haltigen Mediums (40) aus der Leiterplattenund/oder Substrat-Herstellung, welches Computerprogramm-Produkt, wenn es von einem oder mehreren Prozessoren ausgeführt wird, das Verfahren nach einem der Ansprüche 1 bis 9 und/oder die Vorrichtung nach Anspruch 10 oder 11 und/oder die Prozesskontrollvorrichtung (600) nach Anspruch 13 oder 14 steuert.
